# EUROPEAN PATENT SPECIFICATION

(11) **EP 1 901 599 B1**
(45) Date of publication and mention of the grant of the patent: **27.07.2011**
(21) Application number: 06798124.1
(22) Date of filing: 20.09.2006
(51) Int. Cl.: H05K 7/20, F24F 7/08, F25D 1/00, F28F 3/08

(54) **COOLER FOR HEATER-CONTAINING BOX**
KÜHLER FÜR SCHRÄNKE MIT HEIZUNGEN
REFROIDISSEUR POUR BOÎTIER CONTENANT UN ÉLÉMENT CHAUFFANT

(30) Priority: 20.09.2005 JP 2005271635; 29.09.2005 JP 2005284349
(43) Date of publication of application: 19.03.2008
(73) Proprietor: Panasonic Corporation, Kadoma-shi Osaka 571-8501 (JP)
(72) Inventor: NAKANO, Yuuji c/o Matsushita Electr.Ind., Chuo-ku, Osaka-shi,Osaka 540-6207 (JP); HAGIMOTO, Keisuke c/o Matsushita Electr.Ind., Chuo-ku,Osaka-shi,Osaka 540-6207 (JP); FUNADA, Naoyuki c/o Matsushita Electr.Ind., Chuo-ku,Osaka-shi,Osaka 540-6207 (JP); YAMAGUCHI, Toshikazu c/o Matsushita Electr.Ind., Chuo-ku,Osaka-shi,Osaka 540-6207 (JP); MATSUMOTO, Mutsuhiko c/o Matsushita Electr.Ind., Chuo-ku, Osaka-shi,Osaka 540-6207 (JP); SAISHU, Kazuki c/o Matsushita Electr.Ind., Chuo-ku, Osaka-shi,Osaka 540-6207 (JP); SHIBATA, Hiroshi c/o Matsushita Electr.Ind., Chuo-ku, Osaka-shi, Osaka 540-6207 (JP)
(74) Representative: Schwabe - Sandmair - Marx
(86) International application number: PCT/JP2006/318564
(87) International publication number: WO 2007/034797

(56) References cited:
- JP-A- 09 004 902
- JP-A- 10 227 554
- JP-A- 2000 156 580
- JP-A- 2002 324 993
- JP-A- 2003 152 358
- JP-A- 2004 044 962
- JP-A- 2004 286 419
- JP-A- 2004 293 862
- JP-A- 2005 044 857

## Description

### TECHNICAL FIELD

The present invention relates to a box-like structure which is installed outdoor, the box having precision equipment which has a heating element such as an electronic component therein and requires cooling even in winter because of high heat generation, and whose performance and life are greatly affected by temperature. In particular, the present invention relates to a cooling device for the box.

### BACKGROUND ART

Recently, high performance of electronic components and densification of the electronic components with respect to a control board have been advanced, and an amount of heat generated from the control board is being dramatically increased. With this increase, the temperature within the box is likely to increase so that guarantee of operation of the electronic components provided on the control board and the product life are greatly affected by temperature within the box. Therefore, reliability is becoming difficult to be assured unless the temperature within the box is cooled down to a certain temperature or lower.

Document JP 2005044857 A discloses a cooling mechanism with a heat exchangerprovided inside a cabinet. Fans are arranged above a substrate as an object of cooling inside the cabinet for sucking up warm air warmed up by the substrate. The warm air sent upward by the fans is ramified through an air duct provided above the fans. A part of the warm air is guided as a first offshoot by the fans to the heat exchanger.

Document JP 2004 286419 A discloses a heat exchanger for use in a heat exchanging ventilation device. The heat exchanger is constituted by alternately stacking first heat conductive plates and second heat conductive plates, comprising an air trunk rib, a heat conductive face an air trunk end face outer peripheral ribs and an air trunk end face cover integrally molded into a sheet.

Document JP 2000 156580 A discloses a cooler with adjacent high-temperature and low-temperature air streams. Each air stream is divided into several circulation paths. The centrifugal fans generating the air streams are placed such that the circulation paths of each air stream are equalized.

As described in, for example, Unexamined Japanese Patent Publication No. 2001-156478, a cooler for heater-containing box which cools down such type of box by air heat exchanging has been conventionally known to be installed on an outer surface of the box.

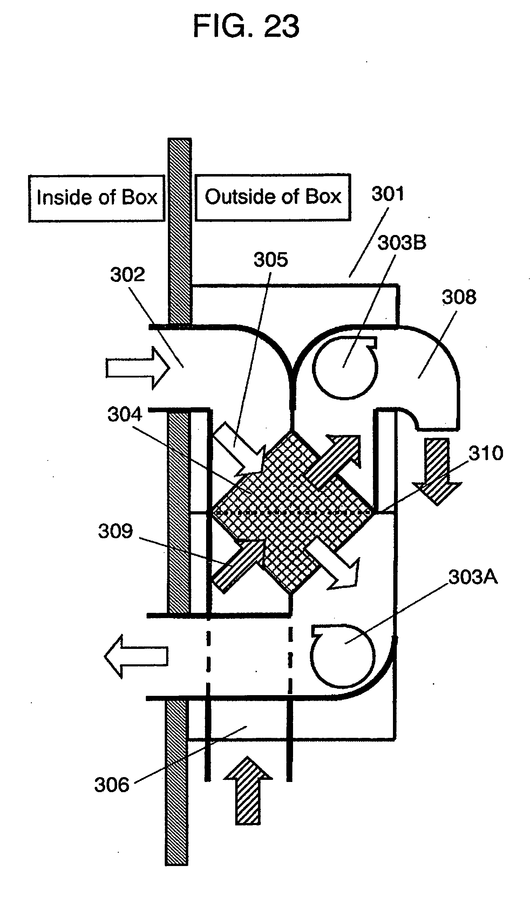

Hereinafter, referring to FIG. 23, the conventional cooler for heater-containing box will be described.

As shown in FIG. 23, the cooler for heater-containing box has, within box 301: inside air path 305 that takes the air of the cooler for heater-containing box via inside air suction port 302 and returns it to the box; outside air path 309 that takes the outside air via outside air suction port 306 and exhausts it via outside air blowout port 308; and diaphragm 310 placed to separate these two air paths 305 and 309. Moreover, outside air fan 303B for conveying air in outside air path 309 is arranged such that the rotating shaft of the fan is perpendicular to the air intake direction via outside air suction port 306, and inside air fan 303A for conveying air in inside air path 305 is arranged such that the rotating shaft of the fan is perpendicular to the air intake direction via inside air suction port 302. Heat exchanger 304, which is arranged at the intersection of the air paths and exchanges sensible heat of the outside air and the inside air, is further included. Box 301 is installed outside of a panel of the box containing heating element, and cools down the box containing heating element.

In such conventional cooler for heater-containing box, since the rotating shaft of the fan is perpendicular to the air inlet direction, the dimension (hereinafter referred to as depth) of the cooler for heater-containing box, which is in the perpendicular direction to the panel of the box containing heating element, is restricted by the fan diameter. Thus, the conventional cooler for heater-containing box has a problem of larger size, and is required to be thinner.

In addition, since one inside air fan and one outside air fan are provided, the cooling device cannot function at all when the inside air fan or the outside air fan is broken. Therefore, it is required that the cooling device work even at the breakage of the fan.

Furthermore, due to the complicated configuration, there are problems of complicated manufacturing, maintenance and construction. Therefore, it is required that the configuration be simple and the manufacturing, maintenance and construction be easily achieved.

Moreover, as described in Unexamined Japanese Patent Publication No. 2004-286419, the conventional counter-current heat exchanger used in the conventional cooler for heater-containing box is a heat exchanger in which first heat transfer plate 101 and second heat transfer plate 102, which are machined by vacuum-molding of polystyrene sheet, are alternately stacked.

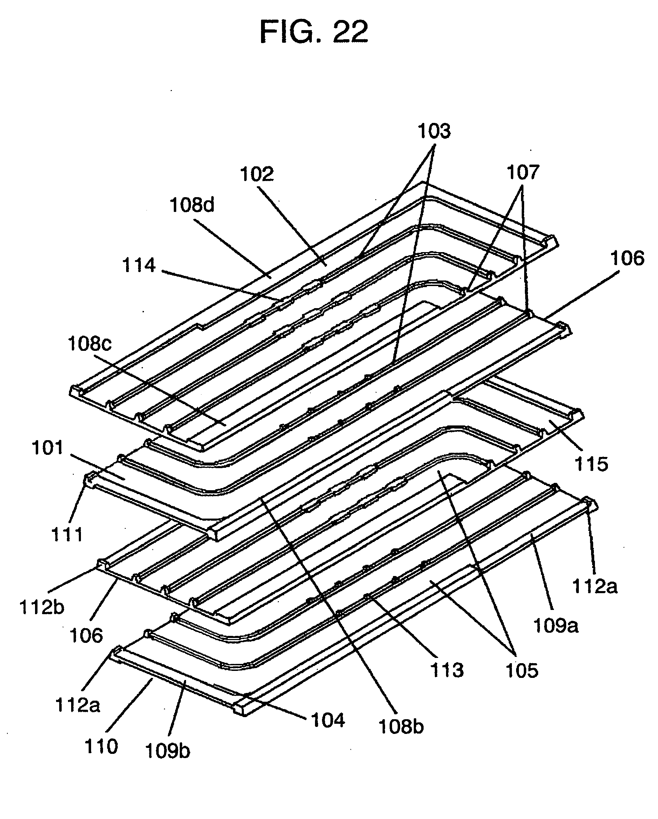

Hereinafter, referring to FIG. 22, the heat exchanger will be described.

First heat transfer plate 101 and second heat transfer plate 102 have a rectangular plane shape, and are obtained by being formed by the vacuum-molding of polystyrene sheet and thereafter cutting extra sheet by a Thomson die or the like. First heat transfer plate 101 has substantially L-shaped air path ribs 103, which are formed to be in a hollow convex shape, in substantially parallel with and at substantially equal spaces to one another. Air path ribs 103 define substantially L-shaped first air path 104 and heat transfer plane 105.

An outlet/inlet portion of first air path 104 is provided with air path end face 106, where the edge of first heat transfer plate 101 is bent to the opposite direction to the protrusion direction of air path ribs 103. Both ends of air path rib 103 are provided with a plurality of hollow convex-shaped first protrusions 107 protruded to the same direction as the protrusion direction of air path ribs 103.

Peripheral rib A (not shown), which is formed to have a hollow convex shape protruded to the same direction as the protrusion direction of air path ribs 103, is provided at the peripheral edge portion other than the inlet and outlet of first air path 104 of first heat transfer plate 101, the peripheral edge portion being sandwiched between the inlet and outlet of first air path 104 and being in substantially parallel with an air path portion serving as the counter current. Peripheral rib A108b having the same shape is provided diagonally to peripheral rib A.

The outer side surfaces of peripheral rib A108b are structured to be bent to the same position as air path end face 106.

Peripheral rib B109 having the same shape is provided at the peripheral edge portion other than the inlet/outlet of first air path 104 of first heat transfer plate 101 and peripheral rib A108b. Peripheral rib B109a of peripheral rib B109 is substantially parallel with peripheral rib A108, and peripheral rib B109b is substantially perpendicular to peripheral rib A108.

Note that an alphabetic lower letter at the end of reference numeral is applied for distinguishing from the similar reference numeral because the reference numerals denote the portions having the same function but different arrangements. It should be also noted that the reference numeral having no additional character includes a plurality of reference numerals with additional character.

Peripheral rib B109 has a hollow convex shape protruded to the same direction as the protrusion direction of air path ribs 103. The center portion of the outer side surface of peripheral rib B109b is bent to the same position as heat transfer plane 105 and is provided with air path opening 110. The both end portions thereof are bent to the same position as air path end face 106 and is provided with air path end face cover 111.

Hollow convex-shaped second protrusion 112a, which is protruded to the same direction as the protrusion direction of air path ribs 103, is provided at the portion closer to air path end face 106 of peripheral rib B109a. Second protrusion 112a is substantially perpendicular to second protrusion 112b provided on second heat transfer plate 102 located thereabove. The upper surface of second protrusion 112a is abutted against the lower surfaces of peripheral ribs B109a and 109b which are provided on second heat transfer plate 102 located thereabove.

Second heat transfer plate 102 has a similarity relation to first heat transfer plate 101, and is formed such that the height of peripheral ribs A108c, 108d of second heat transfer plate 102 of the portions provided at second heat transfer plate 102 is equal to the height of air path rib 103, and moreover such that the width of peripheral ribs A108c, 108d of second heat transfer plate 102 is wider than the width of peripheral rib A108b of first heat transfer plate 101.

Air path rib 103, which is being substantially parallel with first heat transfer plate 101 and peripheral rib A108b of second heat transfer plate 102, is provided with a plurality of hollow convex-shaped protrusions C113 protruded to the same direction to the protrusion direction of air path ribs 103, or air-path-rib stack portions 114 intermittently widening the width of air path rib 103. Protrusions C113 and air-path-rib stack portions 114 at first heat transfer plate 101 and second heat transfer plate 102 are not aligned with respect to the stack direction such that the upper surface of protrusion C113 is abutted against the lower surface of air path rib 103 of second heat transfer plate 102 which is located thereabove, or the upper surface of air-path-rib stack portion 114 is abutted against the lower surface of first heat transfer plate 101 which is located thereabove.

First heat transfer plates 101 and second heat transfer plates 102 which are formed in the above manner are alternately stacked, first air paths 104 and second air paths 115 are alternately provided, and peripheral side surfaces are heat welded and the like, thereby constituting the heat exchanger. Heat exchange is conducted between the fluid flowing in first air path 104 and the fluid flowing in second air path 115.

Such conventional heat exchanger becomes easy to be flexible as the area of the heat transfer plates increases. When the pressure subjected from the fluid flowing in air paths increases, the adjacent air path ribs fit to each other so that the air-path height may become lower and air-flow resistance may increase. Therefore, it is required to maintain the air-path height and suppress the increase in air-flow resistance.

In addition, since the air-path-rib stack portion is wider than the air path rib, a portion of the air-path-rib stack portion has a narrow air-path width and the air-flow resistance increases. Therefore, it is required to suppress the increase in air-flow resistance without decreasing the air-path width.

Moreover, since the plurality of L-shaped air paths formed at the rectangular heat transfer plate has different air-path lengths, the air flow in each air path is different, thereby generating the temperature difference, so-called temperature distribution, of the heat-exchanged air in each air path at the discharging portion. Therefore, the improvement of the temperature distribution is required.

Particularly, when a blowout port of equipment on which the heat exchanger is mounted is close to the outlet of the heat exchanger, low-temperature air caused by the temperature distribution may be blown at low outside temperature, low air flow or the like.

Moreover, when the peripheral side surfaces of the stacked heat transfer plates are heat welded, the height of the opening and the air-path height at the peripheral side may be reduced due to heat contraction. Therefore, it is required to maintain the height of the opening and the air-path height at the peripheral side, and to suppress the increase in air-flow resistance.

Moreover, in order to prevent poor welding during the heat welding, the welding process needs many steps. Therefore, it is required to reduce the steps of the welding process and enhance the productivity.

Moreover, burr is left at the inlet or outlet portion of the air path in cutting the extra sheet from the heat transfer plate, and the burr may cause the height of the opening at the inlet or outlet portion to be lowered and the air-flow resistance to be increased. Therefore, it is required to prevent the decrease in the height of the opening due to the burr and to suppress the increase in the air-flow resistance.

### DISCLOSURE OF THE INVENTION

A cooler for heater-containing box of the present invention has: an inside air path which takes the air of the box containing heating element and circulates the air by returning it into the box containing heating element; and an outside air path which takes the outside air and exhausts it to the outside, wherein an outside air fan for conveying the air on the outside air path and an inside air fan for conveying the air on the inside air path are arranged such that the rotating shaft of each fan is in parallel with the air intake direction, a heat exchanger for exchanging sensible heat of the outside air and the inside air is arranged between the outside air path and the inside air path such that a suction port provided at a longitudinal air-path side of the heat exchanger is aligned with a blowout port of the fan, and a control unit for controlling the operation of the fans is included.

According to the present invention, since the depth dimension of the cooler for heater-containing box is not restricted by the fan diameter, the cooler for heater-containing box having thin depth can be provided.

Moreover, in the heat exchanger used in the cooler for heater-containing box of the present invention, an air-path-retaining-member, which is provided at the portion where the fluids flowing on the first air path and the second air path form a counter current has a curved shape in stacking the first heat transfer plate and the second heat transfer plate.

With this structure, the air-path height can be maintained and the increase in the air-flow resistance can be suppressed, and thereby the heat exchanger capable of suppressing the increase in the air-flow resistance without decreasing the air-path width can be obtained.

### BRIEF DESCRIPTION OF THE DRAWINGS

FIG. 1 is an installation diagram of a cooler for heater-containing box in Embodiment 1 of the present invention;
FIG. 2 is an outline view and a structural diagram at the inside of the cooler for heater-containing box in Embodiments 1 and 8 of the present invention;
FIG. 3 is an outline view at the outside of the cooler for heater-containing box in Embodiments 1 and 5 of the present invention;
FIG. 4 is a structural diagram relating to a temperature detector of the cooler for heater-containing box in Embodiment 2 of the present invention;
FIG. 5 is a structural diagram relating to a heat insulating material of the cooler for heater-containing box in Embodiment 3 of the present invention;
FIG. 6 is a structural diagram relating to a heat insulating material of the cooler for heater-containing box in Embodiment 4 of the present invention;
FIG. 7 is a structural diagram of a fan of the cooler for heater-containing box in Embodiment 6 of the present invention;
FIG. 8 is a structural diagram of a reinforcing member of the cooler for heater-containing box in Embodiment 7 of the present invention;
FIG. 9 is an assembly diagram of a control unit of the cooler for heater-containing box in Embodiment 9 of the present invention;
FIG. 10 is a structural diagram of the control unit of the cooler for heater-containing box in Embodiment 10 of the present invention;
FIG. 11 is a structural diagram relating to a drain pan of the cooler for heater-containing box in Embodiment 11 of the present invention;
FIG. 12 is a structural diagram of a drain pan of the cooler for heater-containing box in Embodiment 12 of the present invention;
FIG. 13 is a schematic exploded perspective view of a heat exchanger according to Embodiments 13 of the present invention;
FIG. 14 is a schematic perspective view of the heat exchanger at the stacking of heat transfer plates according to Embodiment 13 of the present invention;
FIG. 15 is a schematic perspective view of the heat exchanger at the stacking of heat transfer plates from the stacking direction according to Embodiment 13 of the present invention;
FIG. 16 is a schematic cross sectional view in the stacking state of peripheral rib A and peripheral rib B near an opening of the heat exchanger according to Embodiment 13 of the present invention;
FIG. 17 is a schematic cross sectional view of an inlet of the heat exchanger prior to heat welding according to Embodiment 13 of the present invention;
FIG. 18 is a schematic cross sectional view of the inlet of the heat exchanger after the heat welding according to Embodiment 13 of the present invention;
FIG. 19 is a plan view of a first heat transfer plate according to Embodiment 14 of the present invention;
FIG. 20 is a schematic arrangement plan showing a positional relationship between the first heat transfer plate and the fan according to Embodiment 15 of the present invention;
FIG. 21 is a schematic arrangement plan showing the positional relationship between the first heat transfer plate and the fan according to Embodiment 15 of the present invention;
FIG. 22 is a schematic exploded perspective view showing a conventional heat exchanger; and
FIG. 23 is a structural diagram of a conventional cooler for heater-containing box.

### REFERENCE MARKS IN THE DRAWINGS

- 1: first air path
- 1a: first air path
- 1b: first air path
- 1c: first air path
- 1d: first air path
- 1e: first air path
- 1f: first air path
- 1g: first air path
- 1h: first air path
- 1i: first air path
- 1j: first air path
- 2: second air path
- 3: curved air path rib (air-path-retaining-member)
- 4: inlet (inlet portion)
- 4a: inlet
- 5: outlet (outlet portion)
- 6: air path opening
- 6a: air path opening (first opening)
- 6b: air path opening (second opening)
- 7: peripheral rib A (first shielding member)
- 7a: peripheral rib A
- 7b: peripheral rib A
- 8: peripheral rib B (second shielding member)
- 8a: peripheral rib B
- 8b: peripheral rib B
- 8c: peripheral rib B
- 8d: peripheral rib B
- 8e: peripheral rib B
- 8f: peripheral rib B
- 9: side-surface cover (sealing member)
- 10: semicircular recessed portion (peripheral-air-path-retaining- member)
- 11: side-surface reinforcing member (side-surface-retaining- member)
- 12: burr
- 13: fan
- 14: blowout port
- 101: first heat transfer plate
- 102: second heat transfer plate
- 103: air path rib
- 104: first air path
- 105: heat transfer plane
- 106: air path end face (sealing member)
- 107: first protrusion (opening retaining member)
- 108: peripheral rib A
- 109: peripheral rib B
- 110: air path opening
- 111: air path end face cover
- 112: second protrusion
- 113: protrusion C
- 114: air-path-rib stack portion
- 115: second air path
- 210: cooler for heater-containing box
- 200: box for containing heating element
- 260: door
- 201: box
- 202: inside air suction port
- 203: inside air fan
- 204: heat exchanger
- 205: inside air blowout port
- 206: inside air path
- 207: outside air suction port
- 208: outside air fan
- 209: outside air blowout port
- 211: inside-air-temperature-detector
- 212: outside-air-temperature-detector
- 213: control unit
- 214: outside air path
- 215: turbo fan
- 216: inside air blowout port
- 217: outside-air-via-hole
- 218: inside-air-via-hole
- 219: heat insulating material
- 220: guide
- 221: groove
- 222: intermediate wiring
- 223: operating window
- 224: connector
- 225: orifice
- 226: fan fixing plate
- 227: mounting portion
- 228: mounting hole
- 229: reinforcing member
- 230: panel
- 231: protrusion
- 232: slit
- 233: exhaust heat hole
- 234: printed substrate
- 235: handle
- 236: rail
- 237: radiating plate
- 238: printed substrate
- 239: exhaust outlet
- 240: drain pan
- 241: drain pan groove

### PREFERRED EMBODIMENTS FOR CARRYING OUT OF THE INVENTION

A cooler for heater-containing box of the present invention has: an inside air path which takes the air of the box containing heating element and circulates the air by returning it into the box containing heating element; and an outside air path which takes the outside air and exhausts it to the outside, wherein an outside air fan for conveying the air on the outside air path and an inside air fan for conveying the air on the inside air path are arranged such that the rotating shaft of each fan is in parallel with the air intake direction, a heat exchanger for exchanging sensible heat of the outside air and the inside air is arranged between the outside air path and the inside air path such that a suction port provided at a longitudinal air-path side of the heat exchanger is aligned with a blowout port of the fan, and a control unit for controlling the operation of the fans is included. While the depth of a conventional cooler for heater-containing box has been determined by air flow, that is, a fan diameter, the aforementioned structure have an effect of achieving the device structure having a constant depth regardless of air flow, that is, the fan diameter.

In the cooler for heater-containing box of the present invention, a plurality of cooling devices for box containing heating element may be installed. Even when one of inside air fans or outside air fans is broken, the cooling devices for box containing heating element other than the cooler for heater-containing box having such fan work. Therefore, the cooler for heater-containing box has an effect of preventing the loss of cooling function.

Moreover, in the cooler for heater-containing box of the present invention, the blowout port of the heat exchanger may be aligned with the blowout port arranged in the box of the cooler for heater-containing box. Since there is no need to provide any space between the blowout port of the heat exchanger and the blowout port arranged in the box of the cooler for heater-containing box, the cooler for heater-containing box has an effect of having the arrangement that the depth of the cooler for heater-containing box is equal to the depth of the heat exchanger.

Moreover, in the cooler for heater-containing box of the present invention, an outside-air-via-hole may be provided between the outside air fans of each cooler for heater-containing box where an outside-air-temperature-detector is arranged, and an inside-air-via-hole may be provided between the inside air fans of each cooler for heater-containing box where an inside-air-temperature-detector is arranged. The cooler for heater-containing box has effects of enabling the temperature detection of the adjacent two air paths to be shared with one temperature detector, making the arrangement simple, facilitating the manufacturing, and enabling the temperature detection even when one fan is broken.

Moreover, in the cooler for heater-containing box of the present invention, a heat insulating member may be arranged in the box of the cooler for heater-containing box, the heat insulating member forming a guide shape which determines the position of the heat exchanger. The cooler for heater-containing box has effects of enabling the heat exchanger to be easily and reliably installed to fit the guide shape, and preventing the influence of the outside air temperature to the heat exchanger by the heat insulating material.

Moreover, in the cooler for heater-containing box of the present invention, a groove for wirings may be provided with the heat insulating material. By fitting the wirings into the groove at the manufacturing, the cooler for heater-containing box has an effect of ensuring the wirings which are connected from the fans to the control unit to be fixed.

Moreover, in the cooler for heater-containing box of the present invention, an operating window may be provided at a plane with which the heat exchanger of the heat insulating material is in contact. By blocking the operating window in the assembly of the heat exchanger, the dust-proof and water-proof of the connecting portion of the connector can be achieved and the connecting operation of the wirings to the connector can be easily achieved. Therefore, the cooler for heater-containing box has effects of making the arrangement simple and facilitating the manufacturing and the maintenance.

Moreover, in the cooler for heater-containing box of the present invention, a peaked reinforcing member may be provided at the outside air blowout port of the cooler for heater-containing box. The cooler for heater-containing box has effects of preventing the invasion of water into the outside air blowout port and enabling the opening of the outside air blowout port to be reinforced and make it thinner.

Moreover, in the cooler for heater-containing box of the present invention, a fan and an orifice for rectification may be fixed to the same fan fixing plate. By fixing them to the single member, a rotating shaft of a turbo fan and the center of the orifice are easily aligned and the orifice and the fan can be easily aligned with each other at the assembling, as compared with the installation using a plurality of members. Therefore, the cooler for heater-containing box has effects of making the arrangement simple and facilitating the manufacturing.

Moreover, in the cooler for heater-containing box of the present invention, the fan fixing plate can be shaped to be top-bottom and left-right symmetric, and the inside air fan and the outside air fan can be formed with the same structure using the common member. In addition, the mounting portion is U-shaped so that the mounting portion is hooked to a fastening screw or the like, and thereby the cooler for heater-containing box has an effect of preventing the drop of the fans.

Moreover, in the cooler for heater-containing box of the present invention, a reinforcing member, which also serves as a fastening member, may be provided at the corner of the cooler for heater-containing box. The reinforcing member enables a main body to be suspended using the top surface and side surfaces thereof. Therefore, the cooler for heater-containing box has effects of making the arrangement simple and facilitating the manufacturing.

Moreover, in the cooler for heater-containing box of the present invention, a drop prevention member such as a protrusion is provided with a removable panel which forms a plane of the box of the cooler for heater-containing box. Therefore, the cooler for heater-containing box has effects of preventing the drop of the panel when the panel is removed, making the arrangement simple, and facilitating the manufacturing and the maintenance.

Moreover, in the cooler for heater-containing box of the present invention, an exhaust heat hole may be provided at an inside wall surface of the control unit. By generating the air flow exhausted from the exhaust heat hole, the cooler for heater-containing box has effects of cooling down the control unit, reducing the increase in temperature, and becoming thinner.

Moreover, in the cooler for heater-containing box of the present invention, a fixing member which also serves as a handle may be provided at a printed substrate built in the control unit. Therefore, the cooler for heater-containing box has effects of reducing the number of parts and enhancing the productivity and the maintenance.

Moreover, in the cooler for heater-containing box of the present invention, a fixing member which also serves as a radiating member may be provided at the printed substrate built in the control unit. Therefore, the cooler for heater-containing box has effects of reducing the radiating space of the substrate and becoming thinner.

Moreover, in the cooler for heater-containing box of the present invention, a mortar-like drain pan structure may be provided at the bottom surface of the box of the cooler for heater-containing box so that water is pumped up along the inclined surface of the mortar of the drain pan by air blasting of the outside air fan. Therefore, the cooler for heater-containing box has effects of exhausting the water via an exhaust outlet provided above the bottom surface, making the arrangement simple, and facilitating the construction.

Moreover, in the cooler for heater-containing box of the present invention, a groove shape for leading the exhausting water to the exhaust outlet may be provided with the drain pan. Therefore, the cooler for heater-containing box has effects of exhausting water via the exhaust outlet provided at the position other than downwind, making the arrangement simple, and facilitating the construction.

Hereinafter, embodiments of the present invention will be described with reference to the drawings.

### (Embodiment 1)

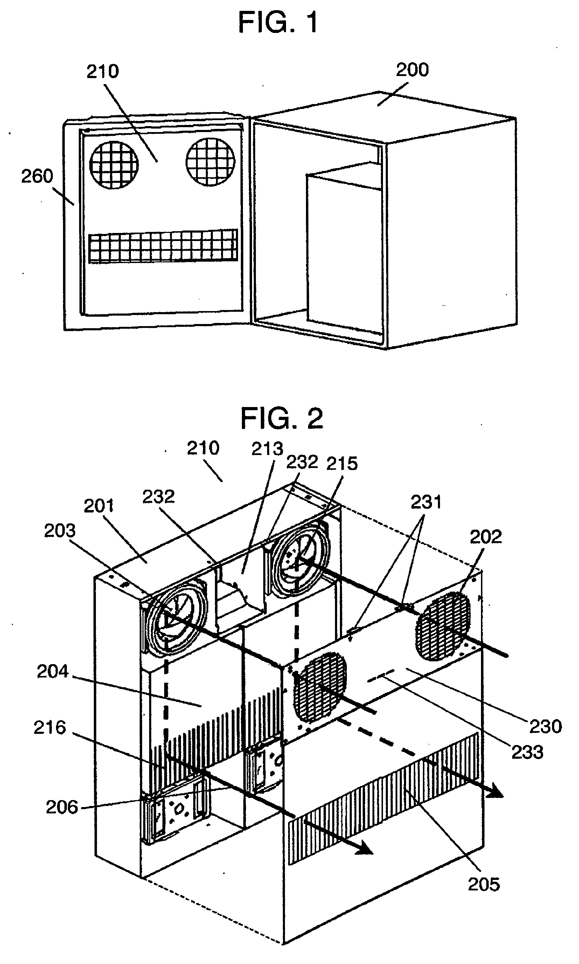

Hereinafter, Embodiment 1 of the present invention will be described with reference to FIGS. 1 to 3.

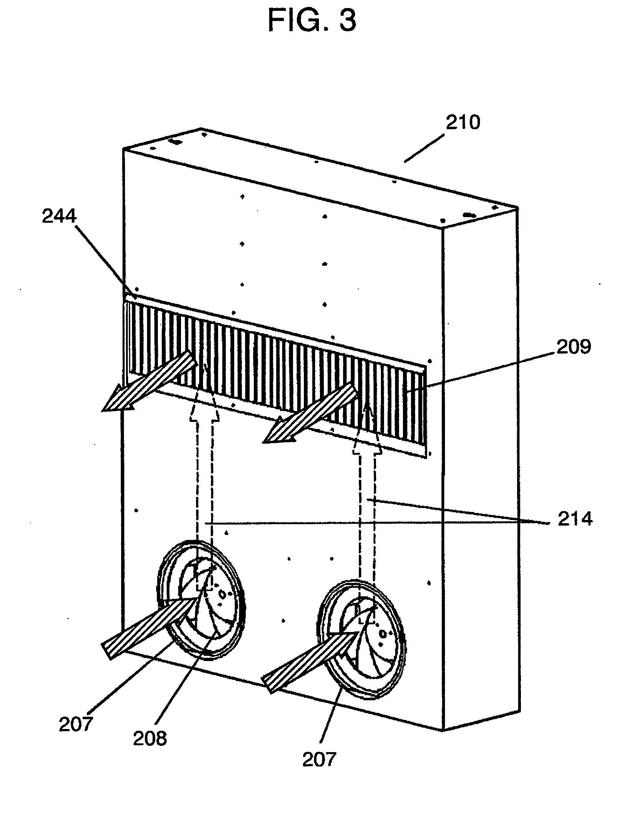

FIG. 1 is an installation diagram of a cooler for heater-containing box in Embodiment 1 of the present invention. FIG. 2 is an outline view and a structural diagram at the inside of the cooler for heater-containing box in Embodiment 1 of the present invention. FIG. 3 is an outline view at the outside of the cooler for heater-containing box in Embodiment 1 of the present invention, and shows the state where a plurality of cooling devices for box containing heating element 100 are installed in the horizontal direction (each figure shows that two cooling devices for box containing heating element are installed).

Cooler for heater-containing box 210 is attached to door 260 of box containing heating element 200, and is structured by "door integral-type" mounting.

Note that cooler for heater-containing box 210 is attached to door 260 of box for containing heating element 200, but cooler for heater-containing box 210 may be externally or internally attached to door 260 or a wall surface of box for containing heating element 200.

Hereinafter, the internal structure of cooler for heater-containing box 210 will be described.

The air within box for containing heating element 200 (hereinafter referred to as internal air) is took into turbo fan 215 of inside air fan 203 via inside air suction port 202, and then passes through heat exchanger 204 and returns back into box for containing heating element 200 via inside air blowout port 205 so as to form circulating inside air path 206.

On the other hand, it is took into turbo fan 215 of outside air fan 208 via outside air suction port 207, and then passes through heat exchanger 204 and is exhausted to the outside air via outside air blowout port 209 so as to form outside air path 214.

Heat exchanger 204 has suction ports on the top surface and the bottom surface in the longitudinal direction, as the suction ports of the longitudinal path, and has blowout ports, which serve as inside air blowout ports 216 and the outside air blowout ports, on parts of the side surfaces in the short-side direction, respectively, so as to form countercurrent air path in the longitudinal direction of the inside of the heat exchanger. Heat exchanger 204 has a substantially rectangular parallelepiped shape having a substantially L-shaped air path communicating the suction ports and the blowout ports, exchanges the sensible heat of the outside air and the inside air, and is arranged between outside air path 214 and inside air path 206.

In addition, heat exchanger 204 is arranged such that the short-side direction is consistent with the depth direction of cooler for heater-containing box 210.

Inside air fan 203 and outside air fan 208 are arranged such that the rotating shaft of turbo fan 215 is in parallel with the air intake direction and each blowout direction of inside air fan 203 and outside air fan 208 is aligned with the suction ports of the longitudinal air path, and control unit 213 is provided for controlling the operations of inside air fan 203 and outside air fan 208.

Inside air blowout port 205 and outside air blowout port 209 provided at the planes of box 201 are arranged such that they are in directly surface contact with and integrated with inside air blowout port 216 and outside air blowout port (not shown) of heat exchanger 204.

With the above structure, cooler for heater-containing box 210 takes the outside air when the internal air temperature is higher than the outside air temperature, exchanges heat to warmer air within box containing heating element 200 by heat exchanger 204. The warmed outside air is exhausted and the cooled air is supplied into box containing heating element 200, and then the temperature within box containing heating element 200 is reduced.

Moreover, since the air-blasting resistance is high due to heat exchanger 204 or the like in the air path, a centrifugal fan is used to blow the air to the cooling device. The depth of cooler for heater-containing box 210 is determined by the air flow, that is, the diameter of turbo fan 215. Therefore, when the diameter of turbo fan 215 is larger, the centrifugal fan becomes thinner regardless of the increase and decrease in air flow since the depth of the turbo fan is consistent.

Furthermore, even when inside air fan 203 or outside air fan 208 of one cooler for heater-containing box A is broken, other cooling devices for box containing heating element A hold the cooling function. All the cooling devices for box containing heating element A are less likely to be simultaneously broken, and the cooling function will not be completely failed.

Furthermore, inside air blowout port 205 and outside air blowout port 209 are in directly surface contact with the inside air blowout port and the outside air blowout port of heat exchanger 204. Therefore, there is no need to provide any space therebetween, and the depth of cooler for heater-containing box A can be thinner.

Furthermore, heat exchanger 204 has the suction ports on the top surface and the bottom surface in the longitudinal direction, as the suction ports of the longitudinal path, and has blowout ports, which serve as inside air blowout port 216 and the outside air blowout port, on parts of the side surfaces in the short-side direction, respectively. In heat exchanger 204, the substantially rectangular parallelepiped shape having a substantially L-shaped air path communicating the suction ports and the blowout ports is arranged such that the short-side direction thereof is aligned with the depth direction of cooler for heater-containing box A. Therefore, the depth of cooler for heater-containing box A can be thinner and the heat exchange can be effectively achieved at the air path portion of the counter current portion in the longitudinal direction.

Note that the description has been given using turbo fan 215 for inside air fan 203 and outside air fan 208, but any type of fan may be used.

### (Embodiment 2)

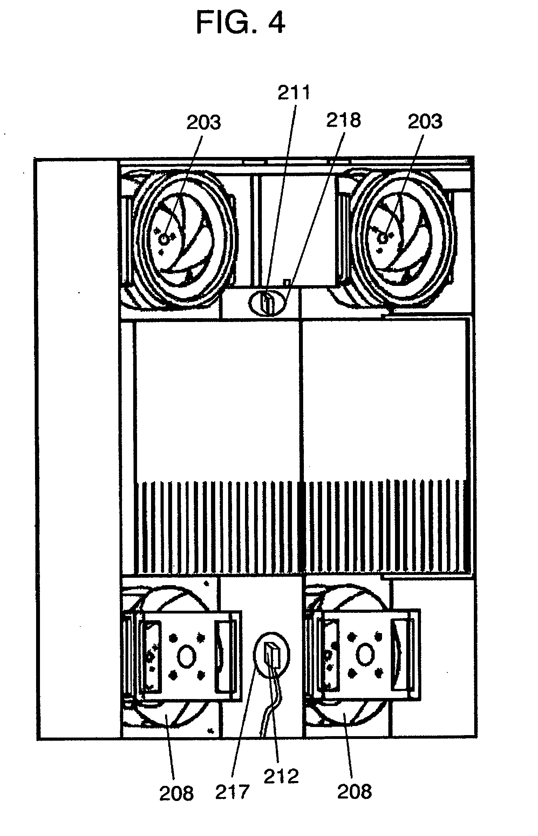

Next, Embodiment 2 of the present invention will be described with reference to FIG. 4.

FIG. 4 is a structural diagram relating to a temperature detector of the cooler for heater-containing box in Embodiment 2 of the present invention, and shows the state where a plurality of cooling devices for box containing heating element are installed. In FIG. 4, the same reference numerals are applied to the same structural elements as in FIGS: 2 and 3 and the descriptions thereof are omitted.

Inside-air-temperature-detector 211 for detecting the temperature of the inside air is arranged in inside-air-via-hole 218 which is provided between inside air fans 203 of the cooling devices for box containing heating element A. Outside-air-temperature-detector 212 for detecting the temperature of the outside air is arranged in outside-air-via-hole 217 which is provided between outside air fans 208 of the cooling devices for box containing heating element A.

With the above structure, each temperature detection of the adjacent two air paths can be shared with one outside-air-temperature-detector 212 and inside-air-temperature-detector 211, and the arrangement structure becomes simple and the manufacturing becomes easier. Moreover, even when one of inside air fan 203 or outside air fan 208 is broken, the temperature can be detected since the other fan operates to blow the air.

### (Embodiment 3)

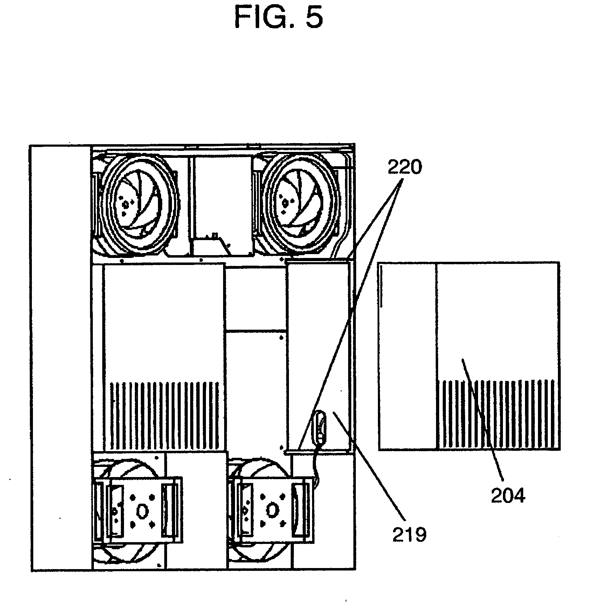

Next, Embodiment 3 of the present invention will be described with reference to FIG. 5.

FIG. 5 shows a structural diagram relating to a heat insulating material of the cooler for heater-containing box in Embodiment 3 of the present invention. In FIG. 5, the same reference numerals are applied to the same structural elements as in FIG. 2 and the descriptions thereof are omitted.

Cooler for heater-containing box 210 is provided with heat insulating material 219 made of foamed polystyrene or the like, which has guide 220 having a convex wall at an edge portion against which, for example, the lower end of heat exchanger 204 is abutted so as to position heat exchanger 204.

With the above structure, heat exchanger 204 can be mounted and positioned such that the lower end of heat exchanger 204 is abutted against guide 220, and thus the attachment becomes easier, the arrangement becomes simple, and the manufacturing and the maintenance become easier. In addition, the effect of heat insulating allows the cooling performance to be prevented from being affected by the temperature of the outside air and the inside air.

### (Embodiment 4)

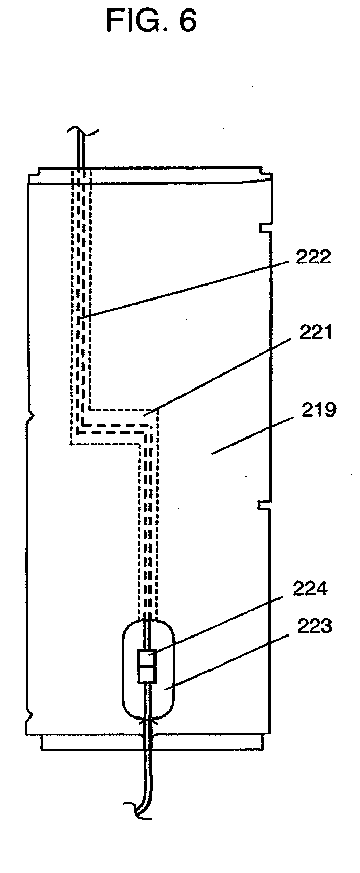

Next, Embodiment 4 of the present invention will be described with reference to FIG. 6.

FIG. 6 shows a structural diagram relating to a heat insulating material of the cooler for heater-containing box in Embodiment 4 of the present invention. In FIG. 6, the same reference numerals are applied to the same structural elements as in FIG. 5 and the descriptions thereof are omitted.

Groove 221 is provided at the rear side of the plane abutting against heat exchanger 204 of heat insulating material 219, and operating window 223 is provided in groove 221.

With the above structure, when intermediate wiring 222, which connects outside air fan 208 and control unit 213, is fitted into groove 221 and heat insulating material 219 is mounted to the box, the wiring is simultaneously achieved. In addition, the wiring is reliably fixed, the arrangement becomes simple, and the manufacturing becomes easier.

Moreover, the connecting portion between outside air fan 208 and connector 224 of intermediate wiring 222 can be housed within heat insulating member 219, and the connecting portion of connector 224 can be easily removed so that the arrangement becomes simple and the manufacturing and the maintenance become easier. Moreover, operating window 223 is blocked by incorporating heat exchanger, and thus the dust-proof and the water-proof of the connecting portion of connector 224 can be achieved.

### (Embodiment 5)

Next, Embodiment 5 of the present invention will be described with reference to FIG. 3.

In FIG. 3, peaked member 244 is provided at a plane of box 201 of cooler for heater-containing box 210, which is located closer to the outside air, and in outside air blowout port 209.

With the above structure, even when outside air blowout port 209 is provided in box 201 of cooler for heater-containing box 210, the attachment of peaked member 244 reinforces box 201 and achieves weather strip.

### (Embodiment 6)

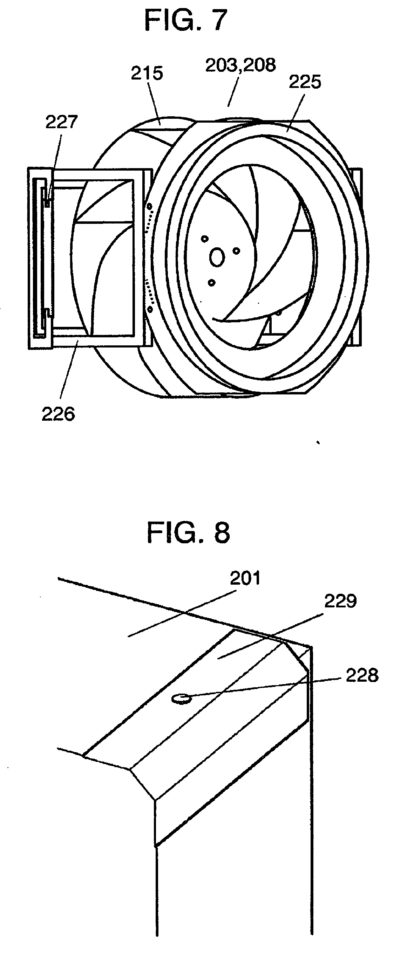

Next, Embodiment 6 of the present invention will be described with reference to FIG. 7.

FIG. 7 shows a structural diagram of a fan of the cooler for heater-containing box in Embodiment 6 of the present invention. In FIG. 7, the same reference numerals are applied to the same structural elements as in FIG. 2 and the descriptions thereof are omitted.

In inside air fan 203 and outside air fan 208, a motor (not shown) coupled to turbo fan 215 and orifice 225 for rectification are fixed to the same fan fixing plate 226.

Moreover, fan fixing plate 226 may be in a top-bottom and left-right symmetric shape, and mounting portion 227 may be U-shaped.

With the above structure, the rotating shaft of turbo fan 215 is likely to be aligned with the center of orifice 225. As a result, the defective assembly due to the accumulation of the tolerances of parts and the erection tolerances can be reduced, and the arrangement becomes simple and the manufacturing becomes easier.

In addition, as being in a top-bottom and left-right symmetric shape, the fan fixing plate can be reversely attached. Even when inside air fan 203 and outside air fan 208 have to be oppositely attached, fan fixing plate 226 can serve as a common member and thus inside air fan 203 and outside air fan 208 can have the same structure. Moreover, since mounting portion 227 is U-shaped, the mounting portion is hooked to a fastening screw or the like at the mounting so as to achieve the prevention of the drop.

### (Embodiment 7)

Next, Embodiment 7 of the present invention will be described with reference to FIG. 8.

Fig. 8 shows a structural diagram of a reinforcing member of the cooler for heater-containing box in Embodiment 7 of the present invention. In FIG. 8, the same reference numerals are applied to the same structural elements as in FIG. 2 and the descriptions thereof are omitted.

Reinforcing member 229 with mounting hole 228, to which an eye bolt or the like can be attached, is provided at the corner of box 201 of cooler for heater-containing box 210 and on the top surface and the side surfaces of box 201.

With the above structure, when the eye bolt or the like is mounted in mounting hole 228, cooler for heater-containing box 210 can be conveyed with a machine and can be easily moved. For example, the direction- of cooler for heater-containing box A can be easily changed on the production line at the manufacturing and can be easily suspended at the packaging, thereby enhancing the productivity

Note that FIG. 8 shows mounting hole 228 provided at the top surface, but it may be provided at the side surfaces.

In addition, FIG. 8 shows one mounting hole 228, but a plurality of mounting holes may be provided.

### (Embodiment 8)

Next, Embodiment 8 of the present invention will be described with reference to FIG. 2.

FIG. 2 is an explanatory diagram of a plane located closer to the inside air of box 201 of cooler for heater-containing box 210. Removable panel 230 is provided with protrusion 231, and slit 232 is provided at the location into which protrusion 231 is fitted at the attachment of panel 230 of box 201.

In addition, exhaust heat hole 233 is provided at a location of panel 230 where control unit 213 is blocked.

The drop prevention member composing of protrusion 231 and slit 232 prevents the drop of panel 230 after the fastening member such as a screw for fixing panel 230 is removed. Therefore, the arrangement becomes simple, and the manufacturing and the maintenance become easier.

In addition, the exhaust heat via exhaust heat hole 233 allows control unit 213 to be cooled down.

Note that even when the inside wall surface of control unit 213 has a wall-surface structure which is not removable, rather than the panel structure, exhaust heat hole 233 can be provided.

### (Embodiment 9)

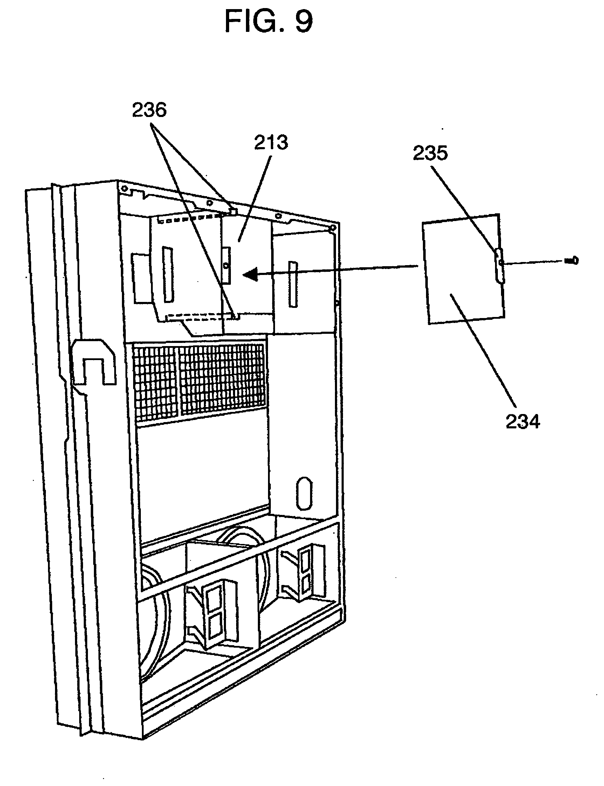

Next, Embodiment 9 of the present invention will be described with reference to FIG. 9.

FIG. 9 shows an assembly diagram of a control unit of the cooler for heater-containing box in Embodiment 9 of the present invention. In FIG. 9, the same reference numerals are applied to the same structural elements as in FIG. 2 and the descriptions thereof are omitted.

Printed substrate 234 is provided with handle 235 having a hole via which a screw or the like is inserted, and control unit 213 is provided with rail 236 for guiding the insertion of printed substrate 234. Printed substrate 234 is fixed to control unit 213 with handle 235.

With the above structure, handle 235 functions to fix printed substrate 234 and handle 235 also serves as a fixing member. The structure eliminates the necessity of additional fixing member and allows the number of parts to be decreased, and thus the arrangement becomes simple and the manufacturing and the maintenance become easier.

### (Embodiment 10)

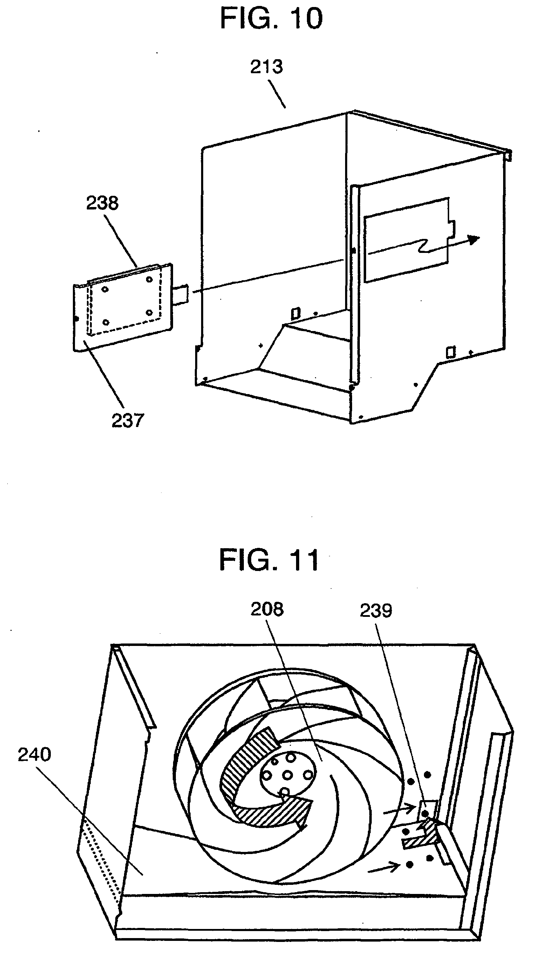

Next, Embodiment 10 of the present invention will be described with reference to FIG. 10.

FIG. 10 shows a structural diagram of the control unit of the cooler for heater-containing box in Embodiment 10 of the present invention. In FIG. 10, the same reference numerals are applied to the same structural elements as in FIG. 2 and the descriptions thereof are omitted.

Printed substrate 238 is provided with radiating plate 237, which is attached to printed substrate 238 by inserting radiating plate 237 into a cutout provided at the outline of control unit 213.

Thereby, radiating plate 237 serves as a part of the outline of control unit 213 and is in contact with inside air path 206. In other words, printed substrate 238 serves as both a fixing member and a radiating member.

With the above structure, there is no need to provide any space for radiation between radiating plate 237 and the outline of control unit 213 when printed substrate 238 is placed within control unit 213, and thereby control unit 213 can be downsized.

### (Embodiment 11)

Next, Embodiment 11 of the present invention will be described with reference to FIG. 11.

FIG. 11 shows a structural diagram relating to a drain pan of the cooler for heater-containing box in Embodiment 11 of the present invention. In FIG. 11, the same reference numerals are applied to the same structural elements as in FIG. 3 and the descriptions thereof are omitted.

The bottom of box 201 of cooler for heater-containing box 210 is provided with exhaust outlet 239 at a location higher than the bottom of the outside-air side surface of box 201. The bottom of box is provided with bowl-like drain pan 240 having an inclined surface whose lowest surface is located below outside air fan 208 and which extends toward exhaust outlet 239.

With the above structure, the rain water invading from the outside and collected in drain pan 240 is pumped up along the mortar-like inclined surface of drain pan 240 by blowing the air with outside air fan 208 without using any additional member such as a pump, so that the water can be exhausted via exhaust outlet 239 which is located higher than the bottom of drain pan 240. As a result, the installation position has more degree of freedom, and the construction becomes easier.

### (Embodiment 12)

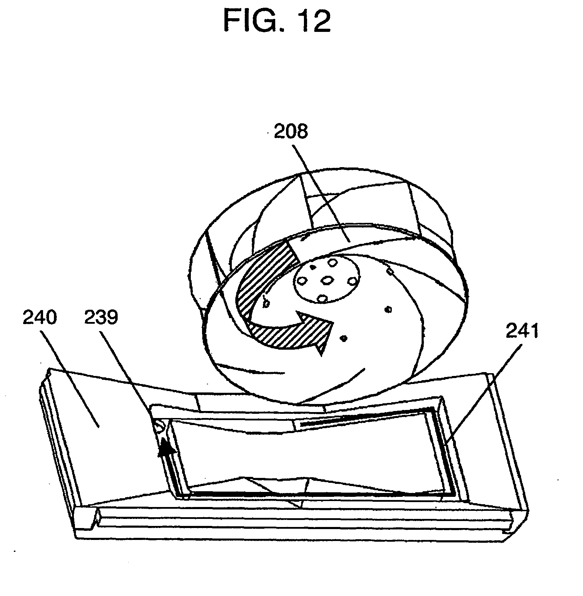

Next, Embodiment 12 of the present invention will be described with reference to FIG. 12.

FIG. 12 shows a structural diagram relating to a drain pan of the cooler for heater-containing box in Embodiment 12 of the present invention. In FIG. 12, the same reference numerals are applied to the same structural elements as in FIGS. 3 and 11 and the descriptions thereof are omitted.

Drain pan 240 is provided with drain pan groove 241 to extend toward exhaust outlet 239 around the lower part of outside air fan 208.

With the structure, the rain water invading from the outside and collected in drain pan 240 can be exhausted via exhaust outlet 239, which is located at the position other than downwind, without using any additional member such as a pump. As a result, the installation position has more degree of freedom, and the construction becomes easier.

The present invention can provide the cooler for heater-containing box having an effect of allowing the depth of the cooler for heater-containing box to be thinner.

Moreover, there can be provided the cooler for heater-containing box having an effect that even when the fan is broken, the fan of another cooler for heater-containing box operates so as to prevent the loss of cooling function.

Moreover, there can be provided the cooler for heater-containing box having effects that the temperature detection of the adjacent two air paths can be shared with one temperature detector, the arrangement is simple and the manufacturing is easy to be made, and the temperature detection can be achieved even when the fan is broken.

Moreover, there can be provided the cooler for heater-containing box having effects that the heat exchanger can be easily and reliably installed, the arrangement is simple, and the manufacturing and the maintenance are easy to be made.

Moreover, there can be provided the cooler for heater-containing box having effects that the wiring connected from the fan to the control unit is reliably fixed, the arrangement is simple, and the manufacturing is easy to be made.

Moreover, there can be provided the cooler for heater-containing box having effects that the connector connecting operation can be easily performed, the arrangement is simple, and the manufacturing and the maintenance are easy to be made.

Moreover, there can be provided the cooler for heater-containing box having effects that water invading into the outside air blowout port is prevented and the opening of the outside air blowout port can be reinforced.

Moreover, there can be provided the cooler for heater-containing box having effects that the orifice and the fan can be easily aligned with each other at the assembly, the arrangement is simple, and the manufacturing is easy to be made.

Moreover, there can be provided the cooler for heater-containing box having effects that the inside air fan and the outside air fan can have the same structure using the common member, the arrangement is simple, the manufacturing and the maintenance are easy to be made.

Moreover, there can be provided the cooler for heater-containing box having effects that the main body can be suspended, the arrangement is simple, and the manufacturing is easy to be made.

Moreover, there can be provided the cooler for heater-containing box having effects that the panel is prevented from being dropped when the panel is removed, the arrangement is simple, and the manufacturing and the maintenance are easy to be made.

Moreover, there can be provided the cooler for heater-containing box having effects that the rise in temperature within the control unit can be decreased and the cooling device is thinner.

Moreover, there can be provided the cooler for heater-containing box having effects that the number of parts can be decreased, the arrangement is simple, the manufacturing and the maintenance are easy to be made.

Moreover, there can be provided the cooler for heater-containing box having effects that the radiation space of the printed substrate can be decreased and the cooling device is thinner.

Moreover, there can be provided the cooler for heater-containing box having effects that the water is pumped up along the mortar-like inclined surface of the drain pan by blasting the air with the outside air fan so as to exhaust the water via the exhaust outlet which is located above the bottom, the arrangement is simple, and the installation position has more degree of freedom.

Moreover, there can be provided the cooler for heater-containing box having effects that the water can be also exhausted via the exhaust outlet which is provided in the direction different from the downwind of the outside air fan, the arrangement is simple, and the installation position has more degree of freedom.

Next, the heat exchanger of the present invention which can be employed in the cooler for heater-containing box of the present invention will be described in detail in the embodiments.

The heat exchanger of the present invention is made such that an air-path-retaining-member, which is provided at a portion where the fluid flowing at the first air path and the second air path forms a counter current in stacking the first heat transfer plate and the second heat transfer plate, has a curved shape.

With this structure, the air-path height can be maintained and the increase in air-flow resistance can be suppressed, and there can be provided the heat exchanger in which the increase in air-flow resistance can be suppressed without decreasing the air-path width. In addition, since the air-path height can be maintained, the thinner heat exchanger can be obtained by narrowing the air-path width and adjusting the air-flow resistance.

In another structure, the air-path-retaining-member, which forms the portion where the fluid flowing at the first air path and the second air path forms the counter current, is arranged at irregular intervals.

With this structure, there can be provided the heat exchanger in which the temperature distribution of the heat-exchanged air at the outlet portion of the heat exchanger can be improved.

In another structure, the air-path-retaining-members are arranged at irregular intervals such that among the plurality of substantially L-shaped air paths, the air path having a short air-path length at the side of the first shielding member, which is far from the blowout port of the fan, has a wide air-path width, and the air path having a long air-path length at the side of the second shielding member, which is close to the blowout port of the fan, has a narrow air-path width.

With this structure, there can be provided the heat exchanger in which the air flow of the air path having a short air-flow length can be reduced and that of the air path having a long air-flow length can be increased, and the temperature distribution of the heat-exchanged air in the outlet of the heat exchanger can be improved.

In another structure, the air-path-retaining-members are arranged at irregular intervals so as to reduce an air flow difference of the plurality of substantially L-shaped air paths in accordance with the shape of the air paths provided in front of and at the back of a carrying member blowing air to the heat exchanger, or the heat exchanger.

With this structure, there can be provided the heat exchanger in which the difference of the air flow in each air path can be reduced, and the temperature distribution of the heat-exchanged air in the outlet of the heat exchanger can be improved.

In another structure, the air-path-retaining-members are arranged at irregular intervals such that among the plurality of substantially L-shaped air paths, the air path having the central portion, which is close to the blowout port of the fan, has a narrow air-path width, and the air path having a short air-path length at the side of the first shielding member and the air path having a long air-path length at the side of the second shielding member have wide air-path widths.

With this structure, there can be provided the heat exchanger in which the difference of the air flow in each air path can be reduced, and the temperature distribution of the heat-exchanged air in the outlet of the heat exchanger can be improved.

In another structure, the air-path-retaining-members are arranged at irregular intervals such that among the plurality of substantially L-shaped air paths, the air path at the central portion has a narrow air-path width, and the air path having a short air-path length at the side of the first shielding member and the air path having a long air-path length at the side of the second shielding member have wide air-path widths.

With this structure, there can be provided the heat exchanger in which the difference of the air flow in each air path can be reduced, and the temperature distribution of the heat-exchanged air in the outlet of the heat exchanger can be improved.

In another structure, a side-surface-retaining-member is arranged at the locations serving as both ends of the first shielding member and corners in the longitudinal direction of the second shielding member, which are formed at the second heat transfer plate, and as the edge portion of the opening of the first heat transfer plate adjacent thereto. At the both ends of the first shielding member and at the both ends of the second shielding member, which is located opposite to the first shielding member, the upper surface of the first shielding member of the first heat transfer plate is abutted against the lower surface of the second shielding member of the second heat transfer plate, the upper surface of the second shielding member of the first heat transfer plate is abutted against the lower surface of the first shielding member of the second heat transfer plate, and the upper surface of the side-surface-retaining-member is abutted against the lower surfaces of the first shielding member and the second shielding member of the first heat transfer plate.

With this structure, there can be provided the heat exchanger in which the deformation due to heat contraction can be prevented, the opening height is maintained at the peripheral side, and the increase in air-flow resistance can be suppressed. In addition, since the opening height can be maintained at the peripheral side, the thinner heat exchanger can be obtained by narrowing the air-path width and adjusting the air-flow resistance while maintaining the air-path height.

In another structure, at least one peripheral air flow retaining member is provided at the portions which do not face the side surfaces of the first shielding member and the second shielding member formed at the first heat transfer plate, and the peripheral-air-path-retaining-member is abutted against the first shielding member and the second shielding member formed at the second heat transfer plate located therebelow.

With this structure, there can be provided the heat exchanger in which the air-path height can be maintained at the peripheral side and the increase in air-flow resistance can be suppressed. In addition, since the air-path height can be maintained, the thinner heat exchanger can be obtained by narrowing the air-path width and adjusting the air-flow resistance.

In another structure, a sealing member formed at the peripheral edge portion is folded back to have a length longer than the air-path height with respect to the heat transfer surface, and the sealing member provided below the inlet portion and the outlet portion is provided with opening B.

With this structure, there can be provided the heat exchanger in which the number of steps for welding can be reduced and the productivity can be enhanced.

In another structure, opening A and opening B are formed such that the height of the opening between the heat transfer surface and the edge portion of the opening is greater than the air-path height in the inlet and the outlet.

With this structure, there can be provided the heat exchanger in which the decrease in the height of the opening due to burr can be prevented, and the increase in air-flow resistance can be suppressed. In addition, since the decrease in the height of the opening can be prevented, the thinner heat exchanger can be obtained by maintaining the air-path height, narrowing the air-path width and adjusting the air-flow resistance.

Hereinafter, the embodiments of the present invention will be described with reference to the drawings.

### (Embodiment 13)

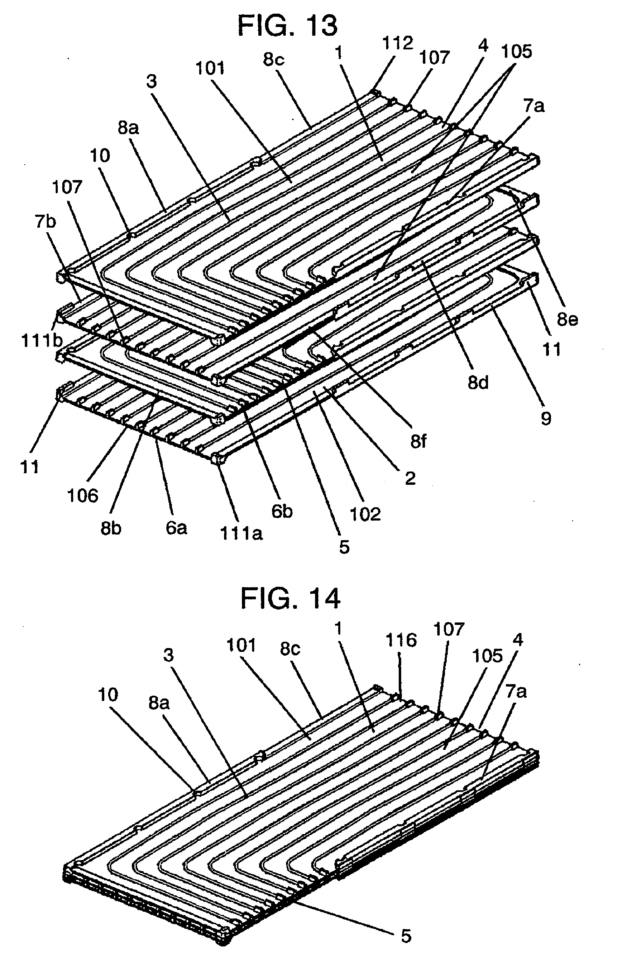

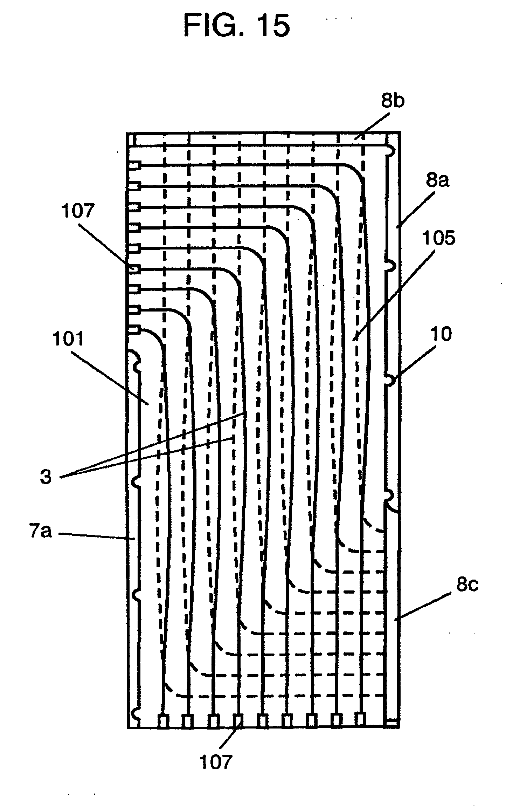

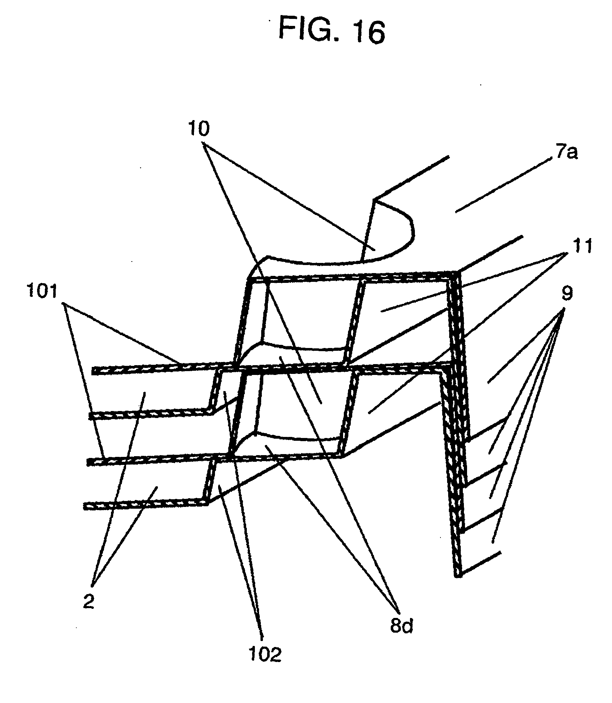

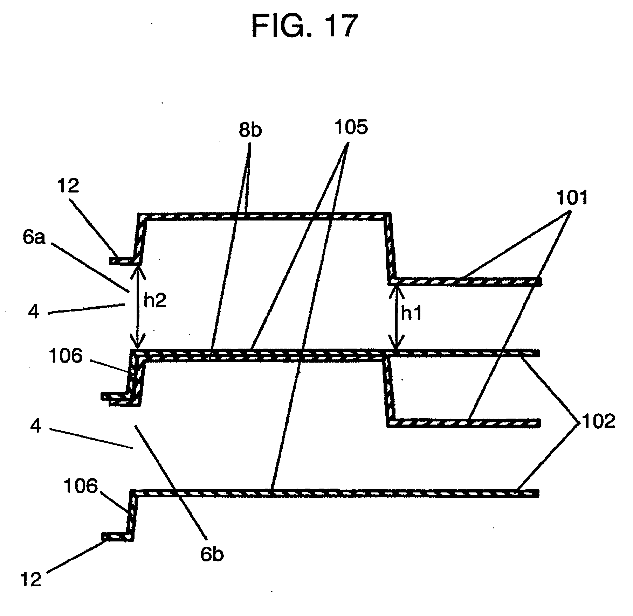

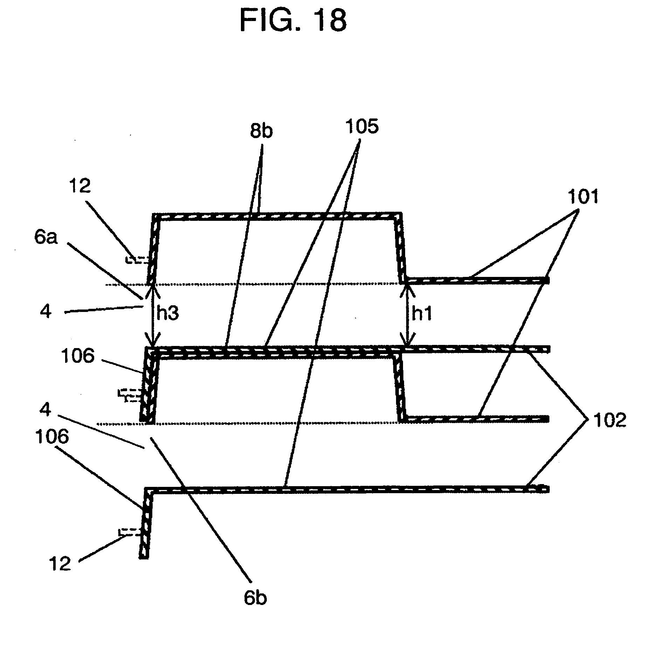

FIG. 13 is a schematic exploded perspective view of a heat exchanger employed in this embodiment. FIG. 14 is a schematic perspective view of the heat exchanger at the stacking of heat transfer plates. FIG. 15 is a schematic perspective view of the heat exchanger at the stacking of heat transfer plates from the stacking direction. FIG. 16 is a schematic cross sectional view in the stacking state of shielding rib A and shielding rib B near an opening. FIG. 17 is a schematic cross sectional view of an inlet prior to heat welding. FIG. 18 is a schematic cross sectional view of the inlet after the heat welding.

In FIGS. 13 and 14, in the heat exchanger constituted by alternately stacking first heat transfer plates 101 and second heat transfer plates 102, first air path 1 and second air path 2 are provided above and below each heat transfer plate. The fluid flowing on first air path 1 and second air path 2 exchanges heat via each heat transfer plate. At the outlet and inlet portions of each air path, the air flowing into in the longitudinal direction and the air flowing out in the short-side direction flow perpendicularly to each other. At the central portion, the airs form a counter current, which flows in the counter direction to each other in the longitudinal direction. The heat transfer plates are integrated by heat welding on the peripheral side surfaces.

In practice, multiple first heat transfer plates 101 and second heat transfer plates 102 are alternately stacked, but four heat transfer plates are shown for simplification.

First heat transfer plate 101 and second heat transfer plate 102 has a rectangular plane shape, and is formed by vacuum molding high-impact polystyrene sheet having a thickness of, for example, 0.2 mm.

First heat transfer plate 101 is formed to be in a hollow convex shape and to have, for example, a convex height of 2.6 mm and a width of 2 mm with respect to the surface of heat transfer surface 105. First heat transfer plate 101 has nine curved air path ribs 3 as substantially L-shaped air-path-retaining-members having a curved counter-current portion to be arranged in substantially parallel and at substantially regular interval. Curved air path ribs 3 form substantially L-shaped first air path 1 and heat transfer surface 105.

Inlets 4 and outlets 5 of first air path 1 are provided with air flow end face 106 as a sealing member in which the edge of first heat transfer plate 101 is bent toward the direction opposite to the protrusion direction of curved air path ribs 3, for example, to the position of 2.4 mm with respect to the surface of heat transfer surface 105. Inlets 4 and outlets 5 are provided with air flow end face cover 111a as a sealing member in which both ends of air path end face 106, e.g., the portion located 10 mm from the ends, are bent to the position of 5.2 mm with respect to the surface which is longer than air path end face 106, e.g., the surface of heat transfer surface 105. Air path opening 6a is formed of air path end face 106 and air path end face cover 111a.

Note that an alphabetic lower letter at the end of reference numeral is applied for distinguishing from the similar reference numeral because the reference numerals denote the portions having the same function but different arrangements. Hereinafter, the similar description will be applied:

The both ends of curved air path rib 3 are provided with a plurality of, for example, 18 first protrusions 107 which are in a hollow convex shape in the same direction as the protrusion direction of curved air path ribs 3 and have the height greater than the height of curved air path ribs 3 such that the height is, for example, 5.2 mm with respect to heat transfer surface 105.

At the peripheral edge portion other than the inlet and outlet of first air path 1 of first heat transfer plate 101 and at the linear portion sandwiched between inlet 4 and outlet 5 of first air path 1, peripheral rib A7a is provided as the first shielding member which is in a hollow convex shape in the same direction of the protrusion direction of curved air path ribs 3 and is formed to have the equal height to first protrusion 107 such that the width is, for example, 10 mm. The upper surface of peripheral rib A7a is in parallel with heat transfer surface 105, and the outer side surfaces thereof are bent to the same position as air path end face cover 111a. Note that peripheral rib A7 corresponding to the first shielding member is a generic name of peripheral ribs A7a and 7b.

At the peripheral edge portion other than inlet 4, outlet 5, and peripheral rib A7a of first air path 1 of first heat transfer plate 101, peripheral rib B8 is formed as the L-shaped second shielding member to have the same width as peripheral rib A7a. Peripheral rib B8a of peripheral rib B8, which is located opposite to peripheral rib A7a, is formed to have the equal height to peripheral rib A7a, and the other peripheral ribs B8b, 8c are formed to have the equal height to curved air path ribs 3. Note that peripheral rib B8 corresponding to the second shielding member is a generic name of peripheral ribs B8a to 8f.

The peripheral side surfaces of peripheral rib B8a are bent to the same position as air path end face cover 111a, and is provided with side surface cover 9 as a sealing member. The portion from the corners of the peripheral side surfaces of peripheral ribs B8b, 8c to the position having the same dimension as peripheral rib A7 is bent to the same position as air path end face cover 111a, and is provided with air path end face cover 111b. The other portions are bent to the position of, for example, 2.2 mm from the upper surface of peripheral ribs B8b, 8c, and are provided with air path opening 6b.

The corners of peripheral ribs B8b, 8c which are adjacent to inlet 4 and outlet 5 are provided with second protrusions 112 which are in a hollowconvex shape in the same direction as the protrusion direction of curved air path ribs 3 and are formed to have the equal height to first protrusion 107.

At the side of each of peripheral rib A7a and peripheral rib B8a, which is located closer to the air path, four semicircular recessed portions 10 serving as the peripheral-air-path-retaining-member are provided to be flush with heat transfer surface 105.

Second heat transfer plate 102 has a similarity relation to first heat transfer plate 101, and is formed such that the heights of peripheral rib A7b and peripheral ribs B8d, 8e, 8f of second heat transfer plate 102 are equal to the height of curved air path ribs 3. Second heat transfer plate is formed to have the same width as peripheral rib A7a of the first heat transfer plate.

On each of peripheral rib A7b and peripheral rib B8d of second heat transfer plate 102, four side-surface reinforcing portions 11 are provided to be adjacent to semicircular recessed portion 10 provided at first heat transfer plate 101 at the stacking, the side-surface reinforcing portion 11 serving as a side-surface-retaining-member which is formed in the same direction as the protrusion direction of curved air path ribs 3, for example at the height of 7.8 mm, with respect to heat transfer surface 105. Side-surface reinforcing portions 11 at both ends are aligned with the ends of peripheral rib A7b and peripheral rib B8d.

In the above structure, when first heat transfer plates 101 and second heat transfer plates 102 are alternately stacked, curved air path ribs 3 are not aligned with curved air path ribs 3 formed at the adjacent heat transfer plate in the stacking direction, as shown in FIG. 15. Therefore, adjacent curved air path ribs 3 are not fitted into one another, the upper surfaces of curved air path ribs 3 are always abutted against the lower surface of the heat transfer plate provided thereabove, and thus the air-path height can be maintained.

This air-path height is designed in terms of the performance and the fabrication of the heat exchanger such as air-flow resistance.

Moreover, as shown in FIG. 16, the upper surface of side-surface reinforcing portion 11 is abutted against the lower surface of peripheral rib A7a of first heat transfer plate 101, and the lower surface of semicircular recessed portion 10 is abutted against the upper surface of peripheral rib B8d of second heat transfer plate 102. Thereby, the decrease in the height of the opening and the decrease in the air-path height at the peripheral side due to the heat contraction at the heat welding can be suppressed.

Moreover, since the peripheral side surface of peripheral rib A7a and the peripheral side surface of peripheral rib B8d of the adjacent heat transfer plates can have a large welding area, the generation of non-welded portion due to the heat contraction can be prevented at the heat welding, and the productivity can be enhanced.

Moreover, as shown in FIG. 17, air path opening 6a and air path opening 6b of inlet 4 are formed such that opening height h2 from the heat transfer surface is higher than air-path height h1, for example h2=3 mm > h1=2.6 mm. Even when burr 12 is left at the cutting portion of air path opening 6a and air path opening 6b at the cutting and burr 12 falls to block off the opening height of inlet 4 at the heat welding as shown in FIG. 18, air path opening 6a and air path opening 6b are designed such that the opening height can be maintained to be equal or more than the air-path height, that is, h3 ≥ h1=2.6 mm. Thereby, the decrease in the opening height due to burr 12 can be suppressed.

In addition, since first heat transfer plate 101 and second heat transfer plate 102 can leave burr 12 within an acceptable range, the productivity is also enhanced.

Note that in this Embodiment 13, high-impact polystyrene sheet is used as the material of heat transfer plates and the heat transfer plates are integrally formed by vacuum molding. However, for the material, other thermoplastic resin films such as polystyrene, polypropylene, polyethylene, polyethylene terephthalate, or the like, thin metal plate such as aluminum, or paper material, microporous resin film, resin-laced paper material having heat transfer property and vapor permeability, or the like can be used. For the molding method, even when the heat transfer plates are integrally formed by other techniques such as air-pressure forming, air-pressure vacuum forming, press molding, or the like, the similar operation and effect can be obtained.

Moreover, the thickness of the sheet is set at 0.2 mm, but it is preferable to use the sheet of sheet material having a thickness in the range of 0.05 to 0.5 mm.

The reason why is that when the thickness is 0.05 mm or less, the sheet material is likely to be damaged such as broken at the formation of roughness shapes and the handling of the molded heat transfer plate, and the molded heat transfer plate has no body and the handling thereof becomes worse. In addition, when the thickness is more than 0.5 mm, the heat transfer property is reduced.

The thinner the sheet thickness is, the heat transfer property increases, and the formability is likely to be decreased. In contrast, the thicker the sheet thickness is, the heat transfer property is likely to be decreased.

Therefore, in order to satisfy the formability and the heat transfer property, it is preferable to use the sheet of sheet material having a thickness in the range of 0.05 to 0.5 mm, and more preferably in the range of 0.15 to 0.25 mm.

Moreover, curved air path rib 3 is shaped to have one curve, but even when it is shaped to have a plurality of curves as long as curved air path ribs 3 of the adjacent heat transfer plates are not fitted into one another at the stacking, the similar operation and effect can be obtained.

Moreover, semicircular recessed portion 10 is employed as the peripheral-air-path-retaining-member, but other shapes can achieve the similar operation and effect as long as it is abutted against the upper surface of peripheral rib B8 of second heat transfer plate 102 located below at the stacking.

Moreover, the dimension and the number of each part are exemplary, and are not particularly limited to the values. Even when each part is appropriately designed in terms of the performance and the fabrication of the heat exchanger, such as air-flow resistance and heat exchange rate, the similar operation and effect can be obtained.

The heat exchanger described in the embodiment can be downsized in the short-side direction by adjusting the air-path width. The depth of the cooler for heater-containing box of the present invention can be further thinner by being mounted on the cooler for heater-containing box described in Embodiments 1 to 12 with inlet 4 aligning with the suction port of the longitudinal air path and outlet 5 aligning with inside air blowout port 216 and the blowout port serving as the outside air blowout port at a portion of the side surface in the short-side direction.

### (Embodiment 14)

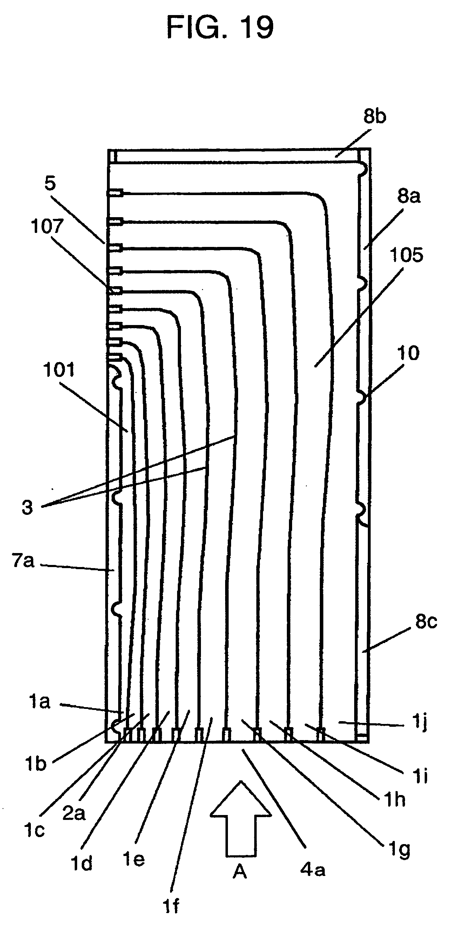

FIG. 19 is a plan view of a first heat transfer plate. Note that the same portions as in Embodiment 13 are denoted by the same reference numerals and exhibit the same operation and effect, and the descriptions thereof are omitted.

As shown in FIG. 19, in substantially L-shaped first air paths 1a to 1j which are formed at first heat transfer plate 101, first air path 1a provided closer to peripheral rib A7a has the shortest air-path length and first air path 1j provided closer to peripheral rib B8 has the longest air-path length.

The first air paths are arranged such that first air path 1a, which has the shortest air-path length, has a narrow air-path width and first air path 1j has a wide width, and the width of each air path is designed to satisfy the relationship of the width of first air path 1a < the width of first air path 1b < the width of first air path 1c < the width of first air path 1d < the width of first air path 1e < the width of first air path 1f < the width of first air path 1g < the width of first air path 1h < the width of first air path 1i < the width of first air path 1j. The width dimension of each air path is appropriately designed depending on the dimension of the heat transfer plate, the air flow, and the fabricating property

Second heat transfer plate 102 is also designed in the same manner, but only first heat transfer plate 101 is shown for simplification.

In the above structure, the fluid flowing from the direction indicated by arrow A in the figure flows into each first air path 1a to 1j, conducts heat exchange, and flows out via outlet 5. Since the air path having the short air-path length has a narrow width and the air path having the long air-path length has a wide width, the difference of the air flow flowing on each air path is decreased. Therefore, as compared with the equal air-path width, the temperature difference of each air path at the outlet can be decreased. In this manner, since the difference of the air flow flowing on each air path is decreased by arranging the air-path-retaining-members at irregular intervals, the temperature difference of each air path at the outlet can be decreased. Moreover, the efficiency of heat exchange of the heat exchanger can be improved and the heat exchanger can be downsized.

Moreover, even when curved air path ribs 3 at inlet 4a of first air path 1a and at the inlet portion of second air path 2 (not shown) are located at the same line, curved air path ribs 3 on the adjacent heat transfer plates at the counter current portion are not fitted into one another. Therefore, each air-path width can be designed as appropriate.

Note that, in the present Embodiment 14, each air path has different width dimensions, but some of air-path widths may be equal, e.g., the width of first air path 1d = the width of first air path 1e.

The depth of the cooler for heater-containing box of the present invention can be further thinner by mounting the heat exchanger described in the present embodiment on the cooler for heater-containing box described in Embodiments 1 to 12.

### (Embodiment 15)

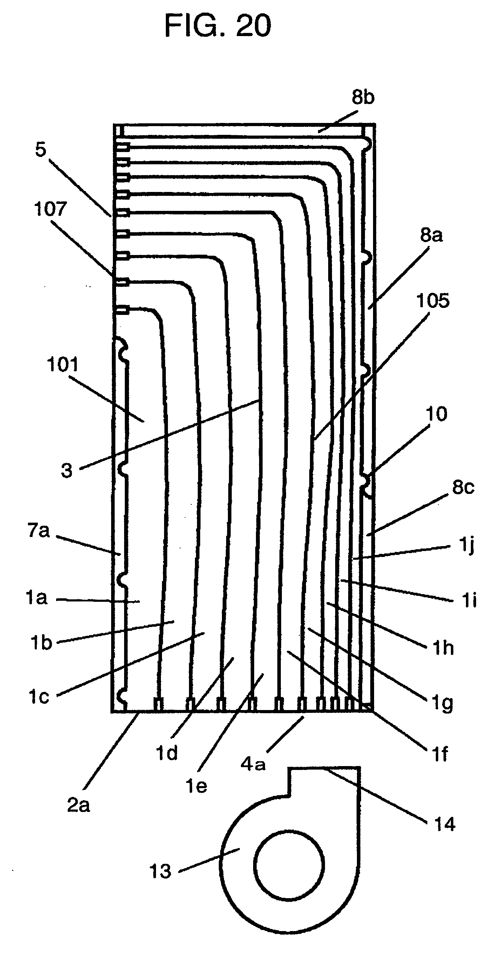

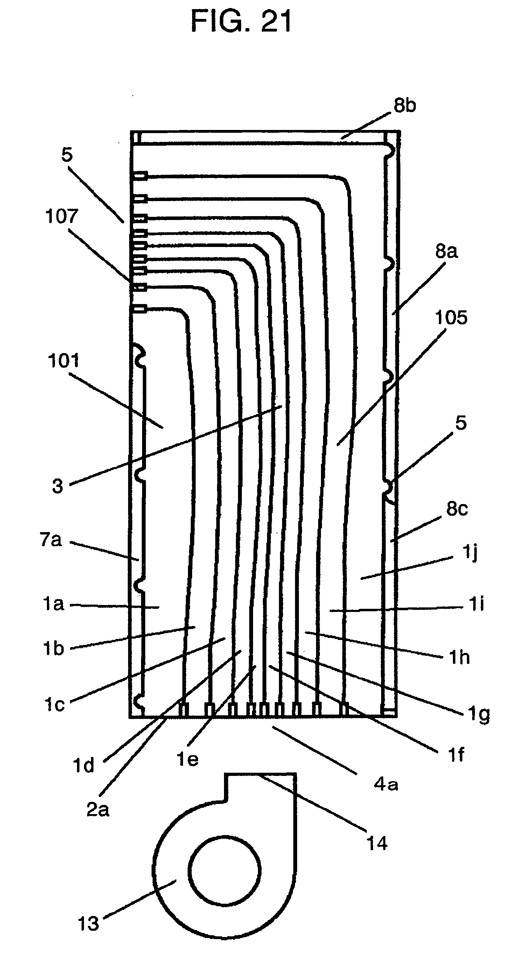

The matters described above are useful for the case where the fluid (air) flowing into the heat exchanger has uniform wind speed and static pressure, and no structure preventing the blowing is provided near the outlet of the heat exchanger. However, the air-path shape allowing such ideal air to flow in the heat exchanger is less likely to be provided in design of the devices. For example, since the size of the blowout port of the fan is inconsistent with the size of the inlet of the heat exchanger, the uniform inflow air cannot be achieved unless there is enough distance between the blowout port of the fan and the inlet of the heat exchanger. However, such air-path shape is less likely to be selected because the size of the device becomes larger. The present invention is useful under such circumstances, and will be described based on FIGS. 20 and 21.

FIGS. 20 and 21 are schematic arrangement plans showing a positional relationship between first heat transfer plate 101 and blowout port 14 of fan 13.

Note that the same portions as in Embodiments 13 and 14 are denoted by the same reference numerals and exhibit the same operation and effect, and the descriptions thereof are omitted.

In FIG. 20, blowout port 14 of fan 13 for carrying the air to first air paths 1a to 1j is arranged at the location closer to the air path having a long air-path length of first air path 1. Curved air path ribs 3 are arranged such that in the air-path width of first air paths 1a to 1j, first air path 1j, below which outlet 14 of fan 13 is arranged and which has the longest air-path length, has a narrow width and first air path 1a has a wide width. The width of each air path is designed to satisfy the relationship of the width of first air path 1a > the width of first air path 1b > the width of first air path 1c > the width of first air path 1d > the width of first air path 1e > the width of first air path 1f > the width of air path A1g > the width of first air path 1h > the width of first air path 1i > the width of first air path 1j. The width dimension of each air path is appropriately designed depending on the dimension of the heat transfer plate, the air flow, and the fabricating property.

Second heat transfer plate 102 is also designed in the same manner, but only first heat transfer plate 101 is shown for simplification.

In the above structure, the fluid blowing out from blowout port 14 of fan 13 flows into each first air path 1a to 1j, conducts heat exchange, and flows out via outlet 5. Since the air path, which is arranged directly above blowout port 14 and has a long air-path length, has a narrow width, and the air path, which is located far from blowout port 14 and has a short air-path length, has a wide width, the difference of the air flow flowing in each air path located closer to first air path 1j having much inflow air flow is decreased due to the relationship to blowout port 14 of fan 13. Therefore, as compared with the case where air-path widths are equal, the temperature difference of each air path at the outlet can be decreased. In this manner, since the difference of the air flow flowing on each air path is decreased by arranging the air-path-retaining-members at irregular intervals, the temperature difference of each air path at the outlet can be decreased. Moreover, the efficiency of heat exchange of the heat exchanger can be improved and the heat exchanger can be downsized.

Moreover, even when curved air path ribs 3 at inlet 4a of first air path 1a and at the inlet portion of second air path 2 (not shown) are located at the same line, curved air path ribs. 3 on the adjacent heat transfer plates are not fitted into one another at the counter current portion. Therefore, each air-path width can be designed as appropriate.

Note that, in the present Embodiment 15, each air path has different width dimensions, but some of air-path widths may be equal, e.g., the width of first air path 1h = the width of first air path 1i, at the portion having the small difference of air flow among each air path due to the arrangement relationship between the fan and the heat exchanger, or the like.

Next, in FIG. 21, blowout port 14 of fan 13 for carrying the air to first air paths 1a to 1j are arranged at the central air-path portion of first air path 1. Curved air path ribs 3 are arranged such that in the air-path width of first air paths 1a to 1j, first air path 1e located at the central air-path portion below which blowout port 14 of fan 13 is arranged has a narrow width and first air paths 1a and 1j located at both ends have wide widths. The width of each air path is designed to satisfy the relationship of the width of first air path 1a > the width of first air path 1b > the width of first air path 1c > the width of first air path 1d > the width of first air path 1e < the width of first air path 1f < the width of first air path 1g < the width of first air path 1h < the width of first air path 1i < the width of first air path 1j. The width dimension of each air path is appropriately designed depending on the dimension of the heat transfer plate, the air flow, and the fabricating property.

Second heat transfer plate 102 is also designed in the same manner, but only first heat transfer plate 101 is shown for simplification.

In the above structure, the fluid blowing out from blowout port 14 of fan 13 flows into each first air path 1a to 1j, conducts heat exchange, and flows out via outlet 5. Since the air path at the central portion, which is arranged directly above outlet 14, has a narrow air-path width, and the air paths at the both ends, which are located far from blowout port 14, have wide air-path widths, the difference of the air flow flowing on each air path at the central portion having much inflow air flow is decreased due to the relationship to blowout port 14 of fan 13. Therefore, as compared with the case where the air-path widths are equal, the temperature difference of each air path at the outlet can be decreased.

Moreover, even when curved air path ribs 3 at inlet 4a of first air path 1a and at the inlet portion of second air path 2 (not shown) are located at the same line, curved air path ribs 3 on the adjacent heat transfer plates are not fitted into one another at the counter current portion. Therefore, each air-path width can be designed as appropriate.

Note that in the present Embodiment 15, each air path has different width dimensions, but some of air-path widths may be equal, e.g., the width of first air path 1e = the width of first air path 1f, at the portion having the small difference of air flow among each air path due to the arrangement relationship between the fan and the heat exchanger, or the like.

It should be noted that in the description on the embodiments of the heat exchanger, first opening 6a is referred to as inlet 4 or inlet 4a when the air actually flows, and is referred to as suction port (with no reference numeral) when it is incorporated into the body of the cooler for heater-containing box.

Moreover, second opening 6b is referred to as outlet 5 when the air flows, and is referred to as blowout port (with no reference numeral), inside air blowout port 216, and outside air blowout port (with no reference numeral) when it is incorporated into the body of the cooler for heater-containing box.

According to the present invention, the air-path-retaining-member at the portion, where the fluid flowing at the first air path and the second air path forms the counter current, is shaped to be curved, and thereby there can be provided the heat exchanger having effects of maintaining the air-path height and suppressing the increase in air-flow resistance.

Moreover, the air-path height is maintained without decreasing the air-path width, and thereby there can be provided the heat exchanger having an effect of suppressing the increase in air-flow resistance.

Moreover, the air-path-retaining-members, which form the portion where the fluid flowing at the first air path and the second air path forms the counter current, are arranged at irregular intervals, and thereby there can be provided the heat exchanger having an effect of improving the temperature distribution.

Moreover, the air-path-retaining-members are arranged at irregular intervals such that among a plurality of substantially L-shaped air paths, the air path having a short air-path length at the side of the first shielding member has a narrow air-path width, and the air path having a long air-path length at the side of the second shielding member has a wide air-path width, and thereby there can be provided the heat exchanger having an effect of improving the temperature distribution.

Moreover, the air-path-retaining-members are arranged at irregular intervals such that among a plurality of substantially L-shaped air paths, the air path having a short air-path length at the side of the first shielding member has a wide air-path width, and the air path having a long air-path length at the side of the second shielding member has a narrow air-path width, and thereby there can be provided the heat exchanger having an effect of improving the temperature distribution.

Moreover, the air-path-retaining-members are arranged at irregular intervals such that among a plurality of substantially L-shaped air paths, the air path provided at the central portion has a narrow air-path width, and the air path having a short air-path length at the side of the first shielding member and the air path having a long air-path length at the side of the second shielding member have wide air-path widths, and thereby there can be provided the heat exchanger having an effect of improving the temperature distribution.

Moreover, the side-surface-retaining-member is arranged at the locations serving as both ends of the first shielding member and corners in the longitudinal direction of the second shielding member, which are formed at the second heat transfer plate, and as the edge portion of the opening of the first heat transfer plate adjacent thereto. At the both ends of the first shielding member and at the both ends of the second shielding member, which is located opposite to the first shielding member, the upper surface of the first shielding member of the first heat transfer plate is abutted against the lower surface of the second shielding member of the second heat transfer plate, the upper surface of the second shielding member of the first heat transfer plate is abutted against the lower surface of the first shielding member of the second heat transfer plate, and the upper surface of the side-surface-retaining-member is abutted against the lower surfaces of the first shielding member and the second shielding member of the first heat transfer plate. Thereby, there can be provided the heat exchanger having effects of maintaining the air-path height at the peripheral side and suppressing the increase in air-flow resistance.

Moreover, at least one peripheral-air-path-retaining-member is provided at the portions which do not face the side surfaces of the first shielding member and the second shielding member formed at the first heat transfer plate, and the peripheral-air-path-retaining-member is abutted against the first shielding member and the second shielding member formed at the second heat transfer plate which is located below the first heat transfer plate. Thereby, the air-path height at the peripheral side is maintained and the increase in air-flow resistance is suppressed.

Moreover, the sealing member formed at the peripheral edge portion is folded back to the position having the length greater than the air-path height with respect to the heat transfer surface, and the second opening is formed at the sealing member provided below the inlet and the outlet. Thereby, there can be provided the heat exchanger having effects of decreasing the number of steps of the welding and improving the productivity.

Moreover, the first opening and the second opening are formed such that the height of the opening between the heat transfer surface and the edge portion of the opening in the inlet and the outlet is greater than the air-path height. Accordingly, the heat exchanger having effects of preventing the decrease in the height of the opening due to burr and suppressing the increase in air-flow resistance can be provided.

Therefore, the efficiency of heat exchange of the heat exchanger can be improved, and the downsized heat exchanger can be provided.

The depth of the cooler for heater-containing box of the present invention can be further thinner by mounting the heat exchanger described in the present embodiment on the cooler for heater-containing box described in Embodiments 1 to 12.

### INDUSTRIAL APPLICABILITY

The present invention relates to a box-like structure which is installed outdoor, such as heat-exchange ventilator, base station for cellular, or simple radio station, the box having precision equipment which has a heating element such as an electronic component therein and requires cooling even in winter because of high heat generation, and whose performance and life are greatly affected by temperature. The present invention is applicable as a cooling device for the box.

## Claims

1. A cooler device for heater-containing box (200) comprising:
an inside air path (206) taking air of the box (200) containing heating element (100) and circulating the air by returning the air into the box containing heating element;
an outside air path (214) taking outside air and exhausting the outside air;
an outside air fan (208) for carrying the air of the outside air path;
an inside air fan (203)for carrying the air of the inside air path;
a heat exchanger (204) for exchanging sensible heat between the outside air and the inside air; and
a control unit (213) for controlling operation of the outside air fan and the inside air fan,
wherein the outside air fan and the inside air fan are arranged such that a rotating shaft of the outside air fan is in parallel with an air intake direction and a rotating shaft of the inside air fan is in parallel with an air intake direction, **characterized by**
the heat exchanger (204) being arranged between the outside air path and the inside air path such that one of suction ports provided at a longitudinal air-path side of the heat exchanger is aligned with a blowout direction of the outside air fan, and the other of the suction ports is aligned with a blowout direction of the inside air fan,
the heat exchanger (204) having a substantially rectangular first heat transfer plate (101) and a substantially rectangular second heat transfer plate (102),
the first heat transfer plate including:
a plurality of substantially L-shaped and hollow air-path-retaining-members (3);
a linear first shielding member and substantially L-shaped second shielding member which are formed at a peripheral portion;
a plurality of substantially L-shaped air paths (1), a heat transfer surface (105), and an inlet (4) and an outlet (5) provided at both ends of the air path, which are formed of the plurality of air-path-retaining-members, a plurality of the first shielding members, and a plurality of the second shielding members;
an opening retaining member provided at an edge portion of the air-path-retaining-member located at the inlet and the outlet;
a sealing member (9) folded back to be substantially perpendicular to the heat transfer surface at an peripheral edge portion of the first heat transfer plate; and
a first opening provided at a location of the sealing member where the inlet and the outlet of the air path are symmetrical with respect to a central point of the heat transfer plate,
wherein the second heat transfer plate has a similar shape to the first heat transfer plate, and has a plurality of side-surface-retaining-members (11) in longitudinal directions of the first shielding member and the second shielding member,
the first heat transfer plate and the second heat transfer plate are integrally formed using a sheet,
the first transfer plate and the second transfer plate are alternately stacked with rotating 180 degree such that the inlet and the outlet of the first heat transfer plate has an opposite positional relationship to the inlet and the outlet of the second heat transfer plate,
a first air path and a second air path are alternately formed by stacking the first heat transfer plate and the second heat transfer plate, and
the air-path-retaining-members at a portion, where a fluid flowing on the first air path and the second air path forms a counter current, have a curved shape.

2. The cooler device for heater-containing box (200) according to claim 1,
wherein the cooler (210) for heater-containing box has a box (201), and wherein blowout ports (216) of the heat exchanger (204) are aligned with an inside air blowout port (205) and an outside air blowout port (209) which are arranged in the box (201).

3. The cooler device for heater-containing box (200) according to claim 1,
wherein a heat insulating material (219) is arranged within the cooler device for heater-containing box, the heat insulating material forming a guide shape (220) which determines a position of the heat exchanger (204).

4. The cooler device for heater-containing box according to claim 1, further comprising:
a heat insulating material (219) having a groove (221) for wiring abutted against the heat exchanger.

5. The cooler device for heater-containing box (200) according to claim 4, wherein the heat insulating material (219) has an operating window (223) on a surface which is in contact with the heat exchanger, and
a connector (224) of a wiring is detachable through the operating window without removing the heat insulating material.

6. The cooler device for heater-containing box (200) according to claim 1,
wherein a peaked member (224) is attached to the outside air blowout port (209).

7. The cooler device for heater-containing box (200) according to claim 1, further comprising:
a fixing plate (226) for fixing an orifice (225) for rectification and the outside air fan (208) or the inside air fan (203),
wherein the outside air fan or the inside air fan, and the orifice are fixed to the fixing plate.

8. The cooler device for heater-containing box (200) according to claim 7,
wherein the fixing plate (226) is shaped to be top-bottom and left-right symmetric, and an attaching portion of the fixing plate is U-shaped.

9. The cooler device for heater-containing box (200) according to claim 1,
wherein a reinforcing member (229) is provided at an edge portion of an upper surface or a side surface of the box (201), and
the reinforcing member also serves as a fixing member.

10. The cooler device for heater-containing box (200) according to claim 1,
wherein a removable panel (230) forming a plane of the cooler device for heater-containing box has a drop prevention member (231, 232).

11. The cooler device for heater-containing box (200) according to claim 1,
wherein an exhaust heat hole (233) is provided at an inside wall surface of the control unit (213).

12. The cooler device for heater-containing box (200) according to claim 1,
wherein the control unit (213) has a built-in printed substrate (234), and
the printed substrate has a fixing member (235) also serving as a handle.

13. The cooler device for heater-containing box (200) according to claim 1,
wherein the control unit (213) has a built-in printed substrate (238), and
the printed substrate has a fixing member (237) also serving as a radiating member.

14. The cooler device for heater-containing box (200) according to claim 1,
wherein an exhaust outlet (239) is provided downwind of the outside air fan (208),
a bowl-like drain pan (240) having an inclined surface toward the exhaust outlet is provided at a bottom surface of the box (200), and
water is pumped up along the inclined surface of the drain pan by blasting air of the outside air fan so that the water can be exhausted via the exhaust outlet which is located above a bottom of the drain pan.

15. The cooler device for heater-containing box (200) according to claim 14,
wherein the exhaust outlet (239) is provided in a direction other than downwind of the outside air fan (208), and
the drain pan (240) has a drain pan groove (241) leading the exhausting water to the exhaust outlet so that the water can be exhausted also via the exhaust outlet provided in the direction other than downwind.

16. The cooler device for heater-containing box (200) according to claim 1,
wherein the air-path-retaining-members at a portion, where the fluid flowing at the first air path and the second air path forms a counter current, are arranged at substantially equal intervals.

17. The cooler device for heater-containing box (200) according to claim 1,
wherein the air-path-retaining-members at a portion, where the fluid flowing at the first air path and the second air path forms a counter current, are arranged at irregular intervals.

18. The cooler device for heater-containing box (200) according to claim 17,
wherein among the plurality of substantially L-shaped air paths (1, 2), the air-path-retaining-members (3) are arranged at irregular intervals such that an air path having a short air-path length at a side of the first shielding member has a narrow air-path width, and an air path having a long air-path length at a side of the second shielding member has a wide air-path width.

19. The cooler device for heater-containing box (200) according to claim 17,
wherein the air-path-retaining-members (3) are arranged at irregular intervals so as to reduce a air flow difference of the plurality of substantially L-shaped air paths (1, 2) in accordance with a shape of the air paths provided in front of and at the back of a carrying member blowing air to the heat exchanger, or the heat exchanger.

20. The cooler device for heater-containing box (200) according to claim 19,
wherein the air-path-retaining-members (3) are arranged at irregular intervals such that among the plurality of substantially L-shaped air paths, an air path having a short air-path length at the side of the first shielding member has a wide air-path width, and an air path having a long air-path length at the side of the second shielding member has a narrow air-path width.

21. The cooler device for heater-containing box (200) according to claim 19,
wherein the air-path-retaining-members (3) are arranged at irregular intervals such that among the plurality of substantially L-shaped air paths (1, 2), an air path at a central portion has a narrow air-path width, and the air path having a short air-path length at the side of the first shielding member and the air path having a long air-path length at the side of the second shielding member have wide air-path widths.

22. The cooler device for heater-containing box (200) according to any one of claims 16 and 17,
wherein the side-surface-retaining-member is arranged at locations serving as both ends of the first shielding member and corners in a longitudinal direction of the second shielding member, which are formed at the second heat transfer plate (102), and as an edge portion of an opening of the first heat transfer plate (101) adjacent thereto, and
at the both ends of the first shielding member and at both ends of the second shielding member which is located opposite to the first shielding member, an upper surface of the first shielding member of the first heat transfer plate is abutted against a lower surface of the second shielding member of the second heat transfer plate, an upper surface of the second shielding member of the first heat transfer plate is abutted against a lower surface of the first shielding member of the second heat transfer plate, and an upper surface of the side-surface-retaining-member is abutted against lower surfaces of the first shielding member and the second shielding member of the first heat transfer plate.

23. The cooler device for heater-containing box (200) according to any one of claims 16 and 17,
wherein at least one peripheral-air-path-retaining-member (3) is provided at portions which do not face side surfaces of the first shielding member and the second shielding member formed at the first heat transfer plate (101), and
the peripheral-air-path-retaining-member (3) is abutted against the first shielding member and the second shielding member formed at the second heat transfer plate located therebelow.

24. The cooler device for heater-containing box (200) according to any one of claims 16 and 17,
wherein the sealing members (9) formed at the peripheral edge portions of the first heat transfer plate (101) and the second heat transfer plate (102) are folded back to have a length longer than an air-path height with respect to the heat transfer surface, and
the sealing members below the inlet (4) and the outlet (5) are provided with a second opening.

25. The cooler device for heater-containing box (200) according to claim 24, wherein the first opening (6a) and the second opening (6b) are formed such that a height of the opening between the heat transfer surface and the edge portion of the first opening or the second opening is greater than an air-path height in the inlet and the outlet when the first heat transfer plates and the second heat transfer plates are alternately stacked.

26. A cooler (210) for heater-containing box (200),
wherein a plurality of the cooling devices for box containing heating element according to one of claims 1 to 25 are provided in accordance with heat generation of the heating element (100) contained in the box (200) containing heating element.

27. The cooler for heater-containing box (200) according to claim 26,
wherein a plurality of the cooling devices for box (200) containing heating element (100) are provided,
an outside-air-via-hole (217) is provided between the outside air fans (208) of the plurality of cooling devices for box containing heating element, in which an outside-air-temperature-detector (212) for detecting an outside air temperature is arranged, and
an inside-air-via-hole (218) is provided between the inside air fans (203) of the plurality of cooling devices for box containing heating element, in which an inside-air-temperature-detector (211) for detecting an inside air temperature is arranged.

## Patentansprüche

1. Kühlungsvorrichtung für einen eine Heizeinrichtung enthaltenden Kasten (200), die umfasst:
einen Innenluftweg (206), der Luft des Kastens (200), der ein Heizelement (100) enthält, aufnimmt und die Luft durch Zurückleiten der Luft in den das Heizelement enthaltenden Kasten umwälzt;
einen Außenluftweg (214), der Außenluft aufnimmt und die Außenluft ausstößt;
ein Außenluftgebläse (208), um die Luft des Außenluftwegs zu transportieren;
ein Innenluftgebläse (203), um die Luft des Innenluftwegs zu transportieren;
einen Wärmetauscher (204), um einen erheblichen Anteil der Wärme zwischen der Außenluft und der Innenluft auszutauschen; und
eine Steuereinheit (213), um den Betrieb des Außenluftgebläses und des Innenluftgebläses zu steuern,
wobei das Außenluftgebläse und das Innenluftgebläse in der Weise angeordnet sind, dass eine Drehwelle des Außenluftgebläses zu einer Luftansaugrichtung parallel ist und eine Drehwelle des Innenluftgebläses zu einer Luftansaugrichtung parallel ist, **dadurch gekennzeichnet, dass**
der Wärmetauscher (204) zwischen dem Außenluftweg und dem Innenluftweg in der Weise angeordnet ist, dass einer der Sauganschlüsse, die auf einer longitudinalen Luftwegseite des Wärmetauschers vorgesehen sind, auf eine Ausblasrichtung des Außenluftgebläses ausgerichtet ist und der andere der Sauganschlüsse auf eine Ausblasrichtung des Innenluftgebläses ausgerichtet ist,
der Wärmetauscher (204) eine im Wesentlichen rechtwinklige erste Wärmeübertragungsplatte (101) und eine im Wesentlichen rechtwinklige zweite Wärmeübertragungsplatte (102) besitzt,
wobei die erste Wärmeübertragungsplatte enthält:
mehrere im Wesentlichen L-förmige und hohle Luftweg-Halteelemente (3);
ein geradliniges erstes Abschirmungselement und ein im Wesentlichen L-förmiges zweites Abschirmungselement, die an einem Umfangsabschnitt ausgebildet sind; und
mehrere im Wesentlichen L-förmige Luftwege (1), eine Wärmeübertragungsoberfläche (105) sowie einen Einlass (4) und einen Auslass (5), die an beiden Enden des Luftwegs vorgesehen sind, die aus den mehreren Luftweg-Halteelementen, mehreren der ersten Abschirmungselemente und mehreren der zweiten Abschirmungselemente gebildet sind;
ein Öffnungshalteelement, das an einem Kantenabschnitt des Luftweg-Halteelements vorgesehen ist, das sich am Einlass und am Auslass befindet;
ein Dichtungselement (9), das zurückgefaltet ist, um zu der Wärmeübertragungsoberfläche an einem Umfangskantenabschnitt der ersten Wärmeübertragungsplatte im Wesentlichen senkrecht zu sein; und
eine erste Öffnung, die an einer Stelle des Dichtungselements vorgesehen ist, wo der Einlass und der Auslass des Luftwegs in Bezug auf einen Mittelpunkt der Wärmeübertragungsplatte symmetrisch sind,
wobei die zweite Wärmeübertragungsplatte eine ähnliche Form wie die erste Wärmeübertragungsplatte hat und mehrere Seitenoberflächen-Halteelemente (11) in Längsrichtungen des ersten Abschirmungselements und des zweiten Abschirmungselements besitzt,
die erste Wärmeübertragungsplatte und die zweite Wärmeübertragungsplatte unter Verwendung einer Lage einteilig ausgebildet sind,
die erste Übertragungsplatte und die zweite Übertragungsplatte verdreht um 180 Grad abwechselnd gestapelt sind, so dass der Einlass und der Auslass der ersten Übertragungsplatte eine entgegengesetzte räumliche Beziehung zu dem Einlass und dem Auslass der zweiten Wärmeübertragungsplatte haben,
ein erster Luftweg und ein zweiter Luftweg durch Stapeln der ersten Wärmeübertragungsplatte und der zweiten Wärmeübertragungsplatte abwechselnd gebildet sind und
die Luftweg-Halteelemente in einem Abschnitt, in dem ein in dem ersten Luftweg und in dem zweiten Luftweg strömendes Fluid einen Gegenstrom bildet, eine gekrümmte Form haben.

2. Kühlungsvorrichtung für eine eine Heizeinrichtung enthaltenden Kasten (200) nach Anspruch 1,
wobei der Kühler (210) für einen eine Heizeinrichtung enthaltenden Kasten einen Kasten (201) besitzt und wobei
Ausblasanschlüsse (216) des Wärmetauschers (204) auf einen Innenluftausblasanschluss (205) und auf einen Außenluftausblasanschluss (209), die im Kasten (201) angeordnet sind, ausgerichtet sind.

3. Kühlungsvorrichtung für einen eine Heizeinrichtung enthaltenden Kasten (200) nach Anspruch 1,
wobei ein Wärmeisolationsmaterial (219) in der Kühlungsvorrichtung für den eine Heizeinrichtung enthaltenden Kasten angeordnet ist, wobei das Wärmeisolationsmaterial eine Führungsform (220) bildet, die eine Position des Wärmetauschers (204) bestimmt.

4. Kühlungsvorrichtung für einen eine Heizeinrichtung enthaltenden Kasten nach Anspruch 1, die ferner umfasst:
ein Wärmeisolationsmaterial (219), das eine Nut (221) für eine Verdrahtung besitzt, die an dem Wärmetauscher anliegt.

5. Kühlungsvorrichtung für einen eine Heizeinrichtung enthaltenden Kasten (200) nach Anspruch 4,
wobei das Wärmeisolationsmaterial (219) auf einer Oberfläche, die mit dem Wärmetauscher in Kontakt ist, ein Arbeitsfenster (223) besitzt und
ein Verbinder (224) einer Verdrahtung durch das Arbeitsfenster hindurch entnehmbar ist, ohne das Wärmeisolationsmaterial zu entfernen.

6. Kühlungsvorrichtung für einen eine Heizeinrichtung enthaltenden Kasten (200) nach Anspruch 1,
wobei an dem Außenluft-Ausblasanschluss (209) ein spitzes Element (224) befestigt ist.

7. Kühlungsvorrichtung für einen eine Heizeinrichtung enthaltenden Kasten (200) nach Anspruch 1, die ferner umfasst:
eine Befestigungsplatte (226) zum Befestigen einer Berichtigungsöffnung (225) und des Außenluftgebläses (208) oder des Innenluftgebläses (203),
wobei das Außenluftgebläse oder das Innenluftgebläse und die Öffnung an der Befestigungsplatte befestigt sind.

8. Kühlungsvorrichtung für einen eine Heizeinrichtung enthaltenden Kasten (200) nach Anspruch 7,
wobei die Befestigungsplatte (226) so geformt ist, dass sie in Aufwärts/Abwärts-Richtung und in Links-Rechts-Richtung symmetrisch ist und ein Befestigungsabschnitt der Befestigungsplatte U-förmig ist.

9. Kühlungsvorrichtung für einen eine Heizeinrichtung enthaltenden Kasten (200) nach Anspruch 1,
wobei ein Verstärkungselement (229) an einem Kantenabschnitt einer oberen Oberfläche oder einer seitlichen Oberfläche des Kastens (201) vorgesehen ist und
das Verstärkungselement auch als ein Befestigungselement dient.

10. Kühlungsvorrichtung für einen eine Heizeinrichtung enthaltenden Kasten (200) nach Anspruch 1,
wobei eine abnehmbare Platte (230), die eine Ebene der Kühlungsvorrichtung für einen eine Heizeinrichtung enthaltenden Kasten bildet, ein Tropfverhinderungselement (231, 232) besitzt.

11. Kühlungsvorrichtung für einen eine Heizeinrichtung enthaltenden Kasten (200) nach Anspruch 1,
wobei ein Abwärmeloch (233) an einer Innenwandoberfläche der Steuereinheit (213) vorgesehen ist.

12. Kühlungsvorrichtung für einen eine Heizeinrichtung enthaltenden Kasten (200) nach Anspruch 1,
wobei die Steuereinheit (213) ein eingebautes gedrucktes Substrat (234) besitzt und
das gedruckte Substrat ein Befestigungselement (235) besitzt, das auch als ein Griff dient.

13. Kühlungsvorrichtung für einen eine Heizeinrichtung enthaltenden Kasten (200) nach Anspruch 1,
wobei die Steuereinheit (213) ein eingebautes gedrucktes Substrat (238) besitzt und
das gedruckte Substrat ein Befestigungselement (237) besitzt, das auch als ein Strahlungselement dient.

14. Kühlungsvorrichtung für einen eine Heizeinrichtung enthaltenden Kasten (200) nach Anspruch 1,
wobei ein Ausstoßauslass (239) stromabseitig des Außenluftgebläses (208) vorgesehen ist,
eine napfförmige Entleerungspfanne (240) mit einer zum Ausstoßauslass geneigten Oberfläche an einer unteren Oberfläche des Kastens (200) vorgesehen ist und
Wasser längs der geneigten Oberfläche der Entleerungspfanne durch Blasen von Luft des Außenluftgebläses nach oben gepumpt wird, so dass das Wasser durch den Ausstoßauslass, der sich über einem Boden der Entleerungspfanne befindet, ausgestoßen werden kann.

15. Kühlungsvorrichtung für einen eine Heizeinrichtung enthaltenden Kasten (200) nach Anspruch 14,
wobei der Ausstoßauslass (239) in einer von der Strömungsrichtung des Außenluftgebläses (208) verschiedenen Richtung vorgesehen ist und
die Entleerungspfanne (240) eine Entleerungspfannennut (241) besitzt, die das Ausstoßwasser zu dem Ausstoßauslass führt, so dass das Wasser auch durch den Ausstoßauslass, der in der von der Strömungsrichtung verschiedenen Richtung vorgesehen ist, ausgestoßen werden kann.

16. Kühlungsvorrichtung für einen eine Heizeinrichtung enthaltenden Kasten (200) nach Anspruch 1,
wobei die Luftweg-Halteelemente in einem Abschnitt, in dem das durch den ersten Luftweg und durch den zweiten Luftweg strömende Fluid einen Gegenstrom bildet, in im Wesentlichen gleichen Intervallen angeordnet sind.

17. Kühlungsvorrichtung für einen eine Heizeinrichtung enthaltenden Kasten (200) nach Anspruch 1,
wobei die Luftweg-Halteelemente in einem Abschnitt, in dem das durch den ersten Luftweg und durch den zweiten Luftweg strömende Fluid einen Gegenstrom bildet, in unregelmäßigen Intervallen angeordnet sind.

18. Kühlungsvorrichtung für einen eine Heizeinrichtung enthaltenden Kasten (200) nach Anspruch 17,
wobei unter den mehreren im Wesentlichen L-förmigen Luftwegen (1, 2) die Luftweg-Halteelemente (3) in unregelmäßigen Intervallen angeordnet sind, so dass ein Luftweg mit einer kurzen Luftweglänge auf einer Seite des ersten Abschirmungselements eine kleine Luftwegbreite besitzt und ein Luftweg mit einer großen Luftweglänge auf eine Seite des zweiten Abschirmungselements eine große Luftwegbreite besitzt.

19. Kühlungsvorrichtung für einen eine Heizeinrichtung enthaltenden Kasten (200) nach Anspruch 17,
wobei die Luftweg-Halteelemente (3) in unregelmäßigen Intervallen angeordnet sind, um eine Luftströmungsdifferenz der mehreren im Wesentlichen L-förmigen Luftwege (1, 2) in Übereinstimmung mit einer Form der Luftwege, die vor und hinter einem Transportelement vorgesehen sind, das Luft zu dem Wärmetauscher transportiert, oder vor und hinter dem Wärmetauscher vorgesehen sind, zu reduzieren.

20. Kühlungsvorrichtung für einen eine Heizeinrichtung enthaltenden Kasten (200) nach Anspruch 19,
wobei die Luftweg-Halteelemente (3) in unregelmäßigen Intervallen angeordnet sind, so dass unter den mehreren im Wesentlichen L-förmigen Luftwegen ein Luftweg mit einer kleinen Luftweglänge auf der Seite des ersten Abschirmungselements eine große Luftwegbreite besitzt und ein Luftweg mit einer großen Luftweglänge auf der Seite des zweiten Abschirmungselements eine kleine Luftwegbreite besitzt.

21. Kühlungsvorrichtung für einen eine Heizeinrichtung enthaltenden Kasten (200) nach Anspruch 19,
wobei die Luftweg-Halteelemente (3) in unregelmäßigen Intervallen angeordnet sind, so dass unter den mehreren im Wesentlichen L-förmigen Luftwegen (1, 2) ein Luftweg in einem Mittelabschnitt eine kleine Luftwegbreite besitzt und der Luftweg mit der kleinen Luftweglänge auf der Seite des ersten Abschirmungselements sowie der Luftweg mit der großen Luftweglänge auf der Seite des zweiten Abschirmungselements große Luftwegbreiten besitzen.

22. Kühlungsvorrichtung für einen eine Heizeinrichtung enthaltenden Kasten (200) nach einem der Ansprüche 16 und 17,
wobei das Seitenoberflächen-Halteelement an Stellen angeordnet ist, die sowohl als Enden des ersten Abschirmungselements als auch als Ecken in einer Längsrichtung des zweiten Abschirmungselements dienen, die an der zweiten Wärmeübertragungsplatte (102) ausgebildet sind, und als ein Kantenabschnitt einer Öffnung der ersten Wärmeübertragungsplatte (101) benachbart hierzu dienen, und
wobei an beiden Enden des ersten Abschirmungselements und an beiden Enden des zweiten Abschirmungselements, die sich gegenüber dem ersten Abschirmungselement befinden, eine obere Oberfläche des ersten Abschirmungselements der ersten Wärmeübertragungsplatte an einer unteren Oberfläche des zweiten Abschirmungselements der zweiten Wärmeübertragungsplatte anliegt, eine obere Oberfläche des zweiten Abschirmungselements der ersten Wärmeübertragungsplatte an einer unteren Oberfläche des ersten Abschirmungselements der zweiten Wärmeübertragungsplatte anliegt und eine obere Oberfläche des Seitenoberflächen-Halteelements an unteren Oberflächen des ersten Abschirmungselements und des zweiten Abschirmungselements der ersten Wärmeübertragungsplatte anliegt.

23. Kühlungsvorrichtung für einen eine Heizeinrichtung enthaltenden Kasten (200) nach einem der Ansprüche 16 und 17,
wobei wenigstens ein Umfangsluftweg-Halteelement (3) in Abschnitten vorgesehen ist, die nicht Seitenoberflächen des ersten Abschirmungselements und des zweiten Abschirmungselements, die an der ersten Wärmeübertragungsplatte (101) ausgebildet sind, zugewandt sind, und
das Umfangsluftweg-Halteelement (3) an dem ersten Abschirmungselement und an dem zweiten Abschirmungselement, die an der darunter befindlichen zweiten Wärmeübertragungsplatte ausgebildet sind, anliegt.

24. Kühlungsvorrichtung für einen eine Heizeinrichtung enthaltenden Kasten (200) nach einem der Ansprüche 16 und 17,
wobei die Dichtungselemente (9), die an den Umfangskantenabschnitten der ersten Wärmeübertragungsplatte (101) und der zweiten Wärmeübertragungsplatte (102) ausgebildet sind, zurückgefaltet sind, so dass sie eine Länge besitzen, die größer als die Luftweghöhe in Bezug auf die Wärmeübertragungsoberfläche ist, und
die Dichtungselemente unter dem Einlass (4) und dem Auslass (5) mit einer zweiten Öffnung versehen sind.

25. Kühlungsvorrichtung für einen eine Heizeinrichtung enthaltenden Kasten (200) nach Anspruch 24,
wobei die erste Öffnung (6a) und die zweite Öffnung (6b) in der Weise ausgebildet sind, dass eine Höhe der Öffnung zwischen der Wärmeübertragungsoberfläche und dem Kantenabschnitt der ersten Öffnung oder der zweiten Öffnung größer ist als eine Luftweghöhe in dem Einlass und in dem Auslass, wenn die ersten Wärmeübertragungsplatten und die zweiten Wärmeübertragungsplatten abwechselnd gestapelt sind.

26. Kühler (210) für einen eine Heizeinrichtung enthaltenden Kasten (200),
wobei mehrere der Kühlungsvorrichtungen für einen Kasten, der ein Heizelement enthält, nach einem der Ansprüche 1 bis 25 in Übereinstimmung mit der Wärmeerzeugung des Heizelements (100), das in dem ein Heizelement enthaltenden Kasten (200) enthalten ist, vorgesehen sind.

27. Kühler für einen eine Heizeinrichtung enthaltenden Kasten (200) nach Anspruch 26,
wobei mehrere der Kühlungsvorrichtungen für den Kasten (200), der ein Heizelement (100) enthält, vorgesehen sind,
ein Außenluftdurchgangsloch (217) zwischen den Außenluftgebläsen (208) der mehreren Kühlungsvorrichtungen für den das Heizelement enthaltenden Kasten vorgesehen ist, in dem ein Außenlufttemperatur-Detektor (212) zum Detektieren einer Außenlufttemperatur angeordnet ist, und
ein Innenluftdurchgangsloch (218) zwischen den Innenluftgebläsen (203) der mehreren Kühlungsvorrichtungen für den das Heizelement enthaltenden Kasten vorgesehen ist, in dem ein Innenlufttemperatur-Detektor (211) zum Detektieren einer Innenlufttemperatur angeordnet ist.

## Revendications

1. Dispositif de refroidissement pour un boîtier (200) contenant un élément chauffant, comprenant :
un trajet d'air intérieur (206) prenant de l'air du boîtier (200) contenant un élément chauffant (100) et faisant circuler l'air en renvoyant l'air dans le boîtier contenant un élément chauffant ;
un trajet d'air extérieur (214) prenant de l'air extérieur et expulsant l'air extérieur ;
un ventilateur à air extérieur (208) destiné à transporter l'air du trajet d'air extérieur ;
un ventilateur à air intérieur (203) destiné à transporter l'air du trajet d'air intérieur ;
un échangeur de chaleur (204) destiné à échanger de la chaleur sensible entre l'air extérieur et l'air intérieur ; et
une unité de commande (213) destinée à commander le fonctionnement du ventilateur à air extérieur et du ventilateur à air intérieur,
dans lequel le ventilateur à air extérieur et le ventilateur à air intérieur sont agencés de sorte qu'un arbre rotatif du ventilateur à air extérieur soit en parallèle avec une direction d'admission d'air et un arbre rotatif du ventilateur à air intérieur soit en parallèle avec une direction d'admission d'air, **caractérisé en ce que** l'échangeur de chaleur (204) est agencé entre le trajet d'air extérieur et le trajet d'air intérieur de sorte qu'un parmi des orifices d'aspiration prévus sur un côté trajet d'air longitudinal de l'échangeur de chaleur soit aligné avec une direction de soufflage du ventilateur à air extérieur, et l'autre parmi les orifices d'aspiration soit aligné avec une direction de soufflage du ventilateur à air intérieur,
l'échangeur de chaleur (204) comporte une première plaque de transfert de chaleur sensiblement rectangulaire (101) et une seconde plaque de transfert de chaleur sensiblement rectangulaire (102),
la première plaque de transfert de chaleur comprenant :
une pluralité d'éléments de maintien de trajet d'air sensiblement en forme de L et creux (3) ;
un premier élément de protection linéaire et un second élément de protection sensiblement en forme de L qui sont formés sur une partie périphérique ;
une pluralité de trajets d'air sensiblement en forme de L (1), une surface de transfert de chaleur (105), et une entrée (4) et une sortie (5) prévues aux deux extrémités du trajet d'air, qui sont formées de la pluralité d'éléments de maintien de trajet d'air,
une pluralité des premiers éléments de protection, et une pluralité des seconds éléments de protection ;
un élément de retenue d'ouverture prévu dans une partie de bord de l'élément de maintien de trajet d'air positionné à l'entrée et la sortie ;
un élément d'étanchéité (9) replié pour être sensiblement perpendiculaire à la surface de transfert de chaleur dans une partie de bord périphérique de la première plaque de transfert de chaleur ; et
une première ouverture prévue dans un emplacement de l'élément d'étanchéité où l'entrée et la sortie du trajet d'air sont symétriques par rapport à un point central de la plaque de transfert de chaleur,
dans lequel la seconde plaque de transfert de chaleur possède une forme similaire à la première plaque de transfert de chaleur, et comporte une pluralité d'éléments de retenue de surface latérale (11) dans des directions longitudinales du premier élément de protection et du second élément de protection,
la première plaque de transfert de chaleur et la seconde plaque de transfert de chaleur sont formées d'un seul tenant en utilisant une feuille,
la première plaque de transfert et la seconde plaque de transfert sont empilées en alternance avec une rotation de 180 degrés de sorte que l'entrée et la sortie de la première plaque de transfert de chaleur présentent une relation positionnelle opposée à l'entrée et la sortie de la seconde plaque de transfert de chaleur,
un premier trajet d'air et un second trajet d'air sont formés en alternance en empilant la première plaque de transfert de chaleur et la seconde plaque de transfert de chaleur, et
les éléments de maintien de trajet d'air, dans une partie où un fluide s'écoulant sur le premier trajet d'air et le second trajet d'air forme un contre-courant, présentent une forme incurvée.

2. Dispositif de refroidissement pour un boîtier (200) contenant un élément chauffant selon la revendication 1,
dans lequel le dispositif de refroidissement (210) pour boîtier contenant un élément chauffant comporte un boîtier (201), et dans lequel
des orifices de soufflage (216) de l'échangeur de chaleur (204) sont alignés avec un orifice de soufflage d'air intérieur (205) et un orifice de soufflage d'air extérieur (209) qui sont agencés dans le boîtier (201).

3. Dispositif de refroidissement pour un boîtier (200) contenant un élément chauffant selon la revendication 1,
dans lequel un matériau isolant thermique (219) est agencé à l'intérieur du dispositif de refroidissement pour boîtier contenant un élément chauffant, le matériau isolant thermique présentant une forme de guidage (220) qui détermine une position de l'échangeur de chaleur (204).

4. Dispositif de refroidissement pour un boîtier contenant un élément chauffant selon la revendication 1, comprenant en outre :
un matériau isolant thermique (219) comportant une rainure (221) pour un câblage prenant appui contre l'échangeur de chaleur.

5. Dispositif de refroidissement pour un boîtier (200) contenant un élément chauffant selon la revendication 4,
dans lequel le matériau isolant thermique (219) comporte une fenêtre d'opération (223) sur une surface qui est en contact avec l'échangeur de chaleur, et un connecteur (224) d'un câblage est séparable à travers la fenêtre d'opération sans retirer le matériau isolant thermique.

6. Dispositif de refroidissement pour un boîtier (200) contenant un élément chauffant selon la revendication 1,
dans lequel un élément pointu (224) est fixé à l'orifice de soufflage d'air extérieur (209).

7. Dispositif de refroidissement pour un boîtier (200) contenant un élément chauffant selon la revendication 1, comprenant en outre :
une plaque de fixation (226) destinée à fixer un orifice (225) pour la rectification et
le ventilateur à air extérieur (208) ou le ventilateur à air intérieur (203),
dans lequel le ventilateur à air extérieur ou le ventilateur à air intérieur, et l'orifice sont fixés à la plaque de fixation.

8. Dispositif de refroidissement pour un boîtier (200) contenant un élément chauffant selon la revendication 7,
dans lequel la plaque de fixation (226) est formée pour être symétrique de haut en bas et de gauche à droite, et une partie de fixation de la plaque de fixation présente une forme de U.

9. Dispositif de refroidissement pour un boîtier (200) contenant un élément chauffant selon la revendication 1,
dans lequel un élément de renfort (229) est prévu dans une partie de bord d'une surface supérieure ou d'une surface latérale du boîtier (201), et
l'élément de renfort sert également d'élément de fixation.

10. Dispositif de refroidissement pour un boîtier (200) contenant un élément chauffant selon la revendication 1, dans lequel un panneau amovible (230) formant un plan du dispositif de refroidissement pour boîtier contenant un élément chauffant comporte un élément antichute (231, 232).

11. Dispositif de refroidissement pour un boîtier (200) contenant un élément chauffant selon la revendication 1,
dans lequel un trou de chaleur d'échappement (233) est prévu sur une paroi intérieure de l'unité de commande (213).

12. Dispositif de refroidissement pour un boîtier (200) contenant un élément chauffant selon la revendication 1,
dans lequel l'unité de commande (213) comporte un substrat imprimé encastré (234), et le substrat imprimé comporte un élément de fixation (235) servant également de poignée.

13. Dispositif de refroidissement pour un boîtier (200) contenant un élément chauffant selon la revendication 1,
dans lequel l'unité de commande (213) comporte un substrat imprimé encastré (238), et le substrat imprimé comporte un élément de fixation (237) servant également d'élément rayonnant.

14. Dispositif de refroidissement pour un boîtier (200) contenant un élément chauffant selon la revendication 1,
dans lequel une sortie d'échappement (239) est prévue dans le sens de l'air du ventilateur à air extérieur (208),
un bac de drainage en forme de bol (240) comportant une surface inclinée vers la sortie d'échappement est prévu sur une surface inférieure du boîtier (200), et
de l'eau est pompée vers le haut le long de la surface inclinée du bac de drainage en soufflant de l'air du ventilateur à air extérieur pour que l'eau puisse être expulsée par l'intermédiaire de la sortie d'échappement qui est positionnée au-dessus d'un fond du bac de drainage.

15. Dispositif de refroidissement pour un boîtier (200) contenant un élément chauffant selon la revendication 14,
dans lequel la sortie d'échappement (239) est prévue dans une direction autre que le sens de l'air du ventilateur à air extérieur (208), et
le bac de drainage (240) comporte une rainure de bac de drainage (241) conduisant l'eau expulsée jusqu'à la sortie d'échappement pour que l'eau puisse être expulsée également par l'intermédiaire de la sortie d'échappement prévue dans la direction autre que le sens de l'air.

16. Dispositif de refroidissement pour un boîtier (200) contenant un élément chauffant selon la revendication 1,
dans lequel les éléments de maintien de trajet d'air, dans une partie où le fluide s'écoulant dans le premier trajet d'air et le second trajet d'air forme un contre-courant, sont agencés à des intervalles sensiblement égaux.

17. Dispositif de refroidissement pour un boîtier (200) contenant un élément chauffant selon la revendication 1,
dans lequel les éléments de maintien de trajet d'air, dans une partie où le fluide s'écoulant dans le premier trajet d'air et le second trajet d'air forme un contre-courant, sont agencés à des intervalles irréguliers.

18. Dispositif de refroidissement pour un boîtier (200) contenant un élément chauffant selon la revendication 17,
dans lequel, parmi la pluralité de trajets d'air sensiblement en forme de L (1, 2), les éléments de maintien de trajet d'air (3) sont agencés à des intervalles irréguliers de sorte qu'un trajet d'air possédant une faible longueur de trajet d'air sur un coté du premier élément de protection possède une faible largeur de trajet d'air, et un trajet d'air possédant une importante longueur de trajet d'air sur un côté du second élément de protection possède une importante largeur de trajet d'air.

19. Dispositif de refroidissement pour un boîtier (200) contenant un élément chauffant selon la revendication 17,
dans lequel les éléments de maintien de trajet d'air (3) sont agencés à des intervalles irréguliers afin de réduire une différence d'écoulement d'air de la pluralité de trajets d'air sensiblement en forme de L (1, 2) conformément avec une forme des trajets d'air prévus à l'avant et à l'arrière d'un élément de transport soufflant de l'air vers l'échangeur de chaleur, ou de l'échangeur de chaleur.

20. Dispositif de refroidissement pour un boîtier (200) contenant un élément chauffant selon la revendication 19,
dans lequel les éléments de maintien de trajet d'air (3) sont agencés à des intervalles irréguliers de sorte que, parmi la pluralité de trajets d'air sensiblement en forme de L, un trajet d'air possédant une faible longueur de trajet d'air sur le côté du premier élément de protection possède une importante largeur de trajet d'air, et un trajet d'air possédant une importante longueur de trajet d'air sur le côté du second élément de protection possède une faible largeur de trajet d'air.

21. Dispositif de refroidissement pour un boîtier (200) contenant un élément chauffant selon la revendication 19,
dans lequel les éléments de maintien de trajet d'air (3) sont agencés à des intervalles irréguliers de sorte que, parmi la pluralité de trajets d'air sensiblement en forme de L (1, 2), un trajet d'air dans une partie centrale possède une faible largeur de trajet d'air, et le trajet d'air possédant une faible longueur de trajet d'air sur le côté du premier élément de protection et le trajet d'air possédant une importante longueur de trajet d'air sur le côté du second élément de protection possèdent d'importantes largeurs de trajet d'air.

22. Dispositif de refroidissement pour un boîtier (200) contenant un élément chauffant selon une quelconque des revendications 16 et 17,
dans lequel l'élément de retenue de surface latérale est agencé dans des emplacements servant d'extrémités du premier élément de protection et de coins dans une direction longitudinale du second élément de protection, qui sont formés dans la seconde plaque de transfert de chaleur (102), et de partie de bord d'une ouverture de la première plaque de transfert de chaleur (101) adjacente à celle-ci, et
aux deux extrémités du premier élément de protection et aux deux extrémités du second élément de protection, qui est positionné en face du premier élément de protection, une surface supérieure du premier élément de protection de la première plaque de transfert de chaleur prend appui contre une surface inférieure du second élément de protection de la seconde plaque de transfert de chaleur, une surface supérieure du second élément de protection de la première plaque de transfert de chaleur prend appui contre une surface inférieure du premier élément de protection de la seconde plaque de transfert de chaleur, et une surface supérieure de l'élément de retenue de surface latérale prend appui contre des surfaces inférieures du premier élément de protection et du second élément de protection de la première plaque de transfert de chaleur.

23. Dispositif de refroidissement pour un boîtier (200) contenant un élément chauffant selon une quelconque des revendications 16 et 17,
dans lequel au moins un élément de maintien de trajet d'air périphérique (3) est prévu dans des parties qui ne font pas face à des surfaces latérales du premier élément de protection et du second élément de protection formés dans la première plaque de transfert de chaleur (101), et
l'élément de maintien de trajet d'air périphérique (3) prend appui contre le premier élément de protection et le second élément de protection formés dans la seconde plaque de transfert de chaleur positionnée en dessous de celle-ci.

24. Dispositif de refroidissement pour un boîtier (200) contenant un élément chauffant selon une quelconque des revendications 16 et 17,
dans lequel les éléments d'étanchéité (9) formés dans les parties de bord périphérique de la première plaque de transfert de chaleur (101) et de la seconde plaque de transfert de chaleur (102) sont repliés pour posséder une longueur supérieure à une hauteur de trajet d'air par rapport à la surface de transfert de chaleur, et
les éléments d'étanchéité en dessous de l'entrée (4) et de la sortie (5) sont pourvus d'une seconde ouverture.

25. Dispositif de refroidissement pour un boîtier (200) contenant un élément chauffant selon la revendication 24,
dans lequel la première ouverture (6a) et la seconde ouverture (6b) sont formées de sorte qu'une hauteur de l'ouverture entre la surface de transfert de chaleur et la partie de bord de la première ouverture ou de la seconde ouverture soit supérieure à une hauteur de trajet d'air dans l'entrée et la sortie lorsque les premières plaques de transfert de chaleur et les secondes plaques de transfert de chaleur sont empilées en alternance.

26. Refroidisseur (210) pour un boîtier (200) contenant un élément chauffant,
dans lequel une pluralité des dispositifs de refroidissement pour un boîtier contenant un élément chauffant selon une des revendications 1 à 25 sont prévus conformément avec une génération de chaleur de l'élément chauffant (100) contenu dans le boîtier (200) contenant un élément chauffant.

27. Refroidisseur pour un boîtier (200) contenant un élément chauffant selon la revendication 26,
dans lequel une pluralité des dispositifs de refroidissement pour un boîtier (200) contenant un élément chauffant (100) sont prévus,
un trou de passage d'air extérieur (217) est prévu entre les ventilateurs à air extérieur (208) de la pluralité de dispositifs de refroidissement pour un boîtier contenant un élément chauffant, dans lequel un détecteur de température d'air extérieur (212) destiné à détecter une température d'air extérieur est agencé, et
un trou de passage d'air intérieur (218) est prévu entre les ventilateurs à air intérieur (203) de la pluralité de dispositifs de refroidissement pour un boîtier contenant un élément chauffant, dans lequel un détecteur de température d'air intérieur (211) destiné à détecter une température d'air intérieur est agencé.
